# EUROPEAN PATENT APPLICATION

(11) **EP 2 779 217 A2**
(43) Date of publication of application: **17.09.2014**
(21) Application number: 14158825.1
(22) Date of filing: 11.03.2014
(51) Int. Cl.: H01L 21/321, C09G 1/02

(54) **Chemical mechanical planarization for tungsten-containing substrates**

(30) Priority: 12.03.2013 US 201361777165 P; 27.12.2013 US 201314142087
(71) Applicant: AIR PRODUCTS AND CHEMICALS, INC., Allentown, PA 18195-1501 (US)
(72) Inventor: Shi, Xiaobo, Chandler, AZ Arizona 85224 (US); Zhou, Hongjun, Chandler, AZ Arizona 85248 (US); Lew, Blake J., Scottsdale, AZ Arizona 85251 (US); Schlueter, James Allen, Phoenix, AZ Arizona 85045 (US); Schwartz, Jo-Ann Theresa, Fountain Hills, AZ Arizona 85268 (US)
(74) Representative: Beck Greener

(57) **Abstract**

Chemical mechanical polishing (CMP) compositions for polishing tungsten or tungsten-containing substrates comprise an abrasive, at least one solid catalyst, a chemical additive selected from the groups consisting of piperazine derivatives, salts of cyanate, and combinations thereof; and a liquid carrier. Systems and processes use the aqueous formulations for polishing tungsten or tungsten-containing substrates.

## Description

### BACKGROUND OF THE INVENTION

This invention relates generally to the chemical-mechanical planarization (CMP) of tungsten-containing substrates on semiconductor wafers.

There are a large number of materials used in the manufacture of integrated circuits such as a semiconductor wafer. The materials generally fall into three categories - dielectric material, adhesion and/or barrier layers, and conductive layers. The use of the various substrates, e.g., dielectric material such as TEOS, plasma-enhanced TEOS (PETEOS), and low-k dielectric materials; barrier/adhesion layers such as tantalum, titanium, tantalum nitride, and titanium nitride; and conductive layers such as copper, aluminum, tungsten, and noble metals are known in the industry.

Integrated circuits are interconnected through the use of well-known multilevel interconnections. Interconnection structures normally have a first layer of metallization, an interconnection layer, a second level of metallization, and typically third and subsequent levels of metallization. Interlevel dielectric materials such as silicon dioxide and sometimes low-k materials are used to electrically isolate the different levels of metallization in a silicon substrate or well. The electrical connections between different interconnection levels are made through the use of metallized vias and in particular tungsten vias. U.S. Patent 4,789,648 describes a method for preparing multiple metallized layers and metallized vias in insulator films. In a similar manner, metal contacts are used to form electrical connections between interconnection levels and devices formed in a well. The metal vias and contacts are generally filled with tungsten and generally employ an adhesion layer such as titanium nitride (TiN) and/or titanium to adhere a metal layer such as a tungsten metal layer to the dielectric material.

In one semiconductor manufacturing process, metallized vias or contacts are formed by a blanket tungsten deposition followed by a CMP step. In a typical process, via holes are etched through the interlevel dielectric (ILD) to interconnection lines or to a semiconductor substrate. Next, a thin adhesion layer such as titanium nitride and/or titanium is generally formed over the ILD and is directed into the etched via hole. Then, a tungsten film is blanket deposited over the adhesion layer and into the via. The deposition is continued until the via hole is filled with tungsten. Finally, the excess tungsten is removed by chemical mechanical polishing (CMP) to form metal vias.

Chemical mechanical planarization (CMP) for planarization of semiconductor substrates is now widely known to those skilled in the art and has been described in numerous patents and open literature publications.

In a typical CMP process, a substrate (e.g., a wafer) is placed in contact with a rotating polishing pad attached to a platen. A CMP slurry, typically an abrasive and chemically reactive mixture, is supplied to the pad during CMP processing of the substrate. During the CMP process, the pad (fixed to the platen) and substrate are rotated while a wafer carrier system or polishing head applies pressure (downward force) against the substrate. The slurry accomplishes the planarization (polishing) process by chemically and mechanically interacting with the substrate film being planarized due to the effect of the rotational movement of the pad parallel to the substrate. Polishing is continued in this manner until the desired film on the substrate is removed with the usual objective being to effectively planarize the substrate. Typically metal CMP slurries contain an abrasive material, such as silica or alumina, suspended in an oxidizing, aqueous medium.

The ratio of the removal rate of a metal (e.g., tungsten) to the removal rate of a dielectric base is called the "selectivity" for removal of the metal in relation to removal of the dielectric during CMP processing of substrates comprised of metal and dielectric material.

When CMP slurries with high selectivity for removal of metal in relation to dielectric are used, the metal layers are easily over-polished creating a depression or "dishing" effect in the metallized areas. This feature distortion is unacceptable due to lithographic and other constraints in semiconductor manufacturing.

Another feature distortion that is unsuitable for semiconductor manufacturing is called "erosion." Erosion is the topography difference between a field of dielectric and a dense array of metal vias or trenches. In CMP, the materials in the dense array may be removed or eroded at a faster rate than the surrounding field of dielectric. This causes a topography difference between the field of dielectric and the dense metal (e.g., copper or tungsten) array.

As industry standards trend toward smaller device features, there is a continuous developing need for tungsten CMP slurries that deliver superior planarization of the nanostructures of IC chips. Specifically, for 28nm technology nodes and beyond applications, slurry products must deliver tunable removal rate and tunable selectivity between metal and dielectric, reduce the erosion and dishing while maintaining sufficient removal rate.

There is a significant need for tungsten CMP process(es) and slurry(s) that afford low dishing and plug recess effects especially in view of the fact that the semiconductor industry continues to move towards smaller and smaller feature sizes. The present invention may provide a solution to this significant need.

The tungsten CMP slurry composition described herein can be tailored to provide tunable, effective polishing at desired polishing rates, controlled polishing selectivity of tungsten to other materials, such as dielectric materials, while providing lower static etching rates to minimize surface imperfections, defects, corrosion, and erosion of oxide in areas with tungsten vias.

### BRIEF SUMMARY OF THE INVENTION

This invention is useful for tungsten CMP where low dishing/plug recess, low array erosion on planarized substrates, maintaining or boosting tungsten film removal rates, and maintaining tunable and/or high selectivity for tungsten are desired and/or required.

In one aspect, the invention provides a tungsten chemical mechanical polishing (CMP) composition comprising:
a) a nano-sized abrasive;
b) a solid catalyst of iron compounds coated particles;
c) a chemical additive selected from the groups consisting of piperazine derivatives, salts of cyanate, and combinations thereof;
d) an oxidizer, and
e) remaining is substantially liquid carrier;
wherein pH of the CMP composition is from about 2.0 to about 8.

In another aspect, the invention provides a process of chemical mechanical polishing a tungsten containing semiconductor substrate, comprising steps of:
a) providing a polishing pad;
b) providing a chemical mechanical polishing composition comprising
   1) a nano-sized abrasive;
   2) a solid catalyst of iron compounds coated particles;
   3) a chemical additive selected from the groups consisting of piperazine derivatives, salts of cyanate, and combinations thereof;
   4) an oxidizer;
   5) remaining is substantially liquid carrier; and
      wherein pH of the composition is from about 2.0 to about 8;
c) contacting the surface of the semiconductor substrate with the polishing pad and the chemical mechanical polishing composition; and
d) polishing the surface of the semiconductor substrate;
wherein at least a portion of the surface containing tungsten is in contact with both the polishing pad and the chemical mechanical polishing composition.

In yet another aspect, the invention provides a process of a selective chemical mechanical polishing comprising steps of:
a) providing a semiconductor substrate having a surface containing tungsten and at least one other material;
b) providing a polishing pad;
c) providing a chemical mechanical polishing (CMP) composition comprising
   1) a nano-sized abrasive;
   2) a solid catalyst of iron compounds coated particles;
   3) chemical additive selected from the groups consisting of piperazine derivatives, salts of cyanate, and combinations thereof;
   4) an oxidizer; and
   5) remaining is substantially liquid carrier;
      wherein pH of the CMP composition is from about 2.0 to about 8;
d) contacting the surface of the semiconductor substrate with the polishing pad and the chemical mechanical polishing composition; and
e) polishing the surface of the semiconductor;
wherein at least a portion of the surface containing tungsten is in contact with both the polishing pad and the chemical mechanical polishing composition; and ratio of removal rate of tungsten to removal rate of the at least one other material is equal or greater than 1.

In yet another aspect, the invention provides a system of selective chemical mechanical polishing comprising:
a) a semiconductor substrate having a surface containing tungsten and at least one other material;
b) a polishing pad;
c) a chemical mechanical polishing (CMP) composition comprising
   1) a nano-sized abrasive;
   2) a solid catalyst of iron compounds coated particles;
   3) chemical additive selected from the groups consisting of piperazine derivatives, salts of cyanate, and combinations thereof;
   4) an oxidizer; and
   5) remaining is substantially liquid carrier;
wherein pH of the CMP composition is from about 2.0 to about 8; wherein at least a portion of the surface containing tungsten is in contact with both the polishing pad and the chemical mechanical polishing composition.

Optionally, the chemical mechanical polishing (CMP) composition further comprises one or more of the following:
a corrosion inhibitor;
a pH buffering agent;
a surfactant; and
a biocide when pH of the polishing composition is between 5.0 to 8.0.

Typically, the nano-sized abrasive is selected from the group consisting of silica, alumina, ceria, titania, zirconia, and combinations thereof.

The solid catalyst is the iron compounds coated particles. The particles being used for the preparation of the solid catalyst suitably include colloidal silica and other types of colloidal or nano-sized inorganic metal oxide particles.

The examples of piperazine derivatives are, but are not limited to, substituted mono-amino piperazine derivatives, and substituted bis-amino piperazine derivatives and combinations thereof.

The examples of salts of cyanate are, but are not limited to, potassium cyanate, sodium cyanate, ammonium cyanate, and tetraalkyl ammonium cyanate.

Features of the invention include:
#1. A tungsten chemical mechanical polishing (CMP) composition comprising:
   a) 0.1 wt% to 25 wt% nano-sized abrasive selected from the group consisting of silica, alumina, ceria, titania, zirconia, and combinations thereof;
   b) 0.1 wt% to 0.5wt% solid catalyst of iron compounds coated particles selected from the group consisting of iron compounds coated colloidal silica, colloidal or nano-sized inorganic metal oxide particles and combinations thereof;
   c) 0.0001 wt% to 0.5 wt% chemical additive selected from the groups consisting of piperazine derivatives, salts of cyanate, and combinations thereof;
   d) 0.5 wt% to 10 wt% oxidizer and
   e) remaining is liquid carrier;
      wherein pH of the CMP composition is from about 2.0 to about 8;
#2. The tungsten chemical mechanical polishing (CMP) composition of #1, wherein the chemical additive is the piperazine derivative having a general molecular structure of: 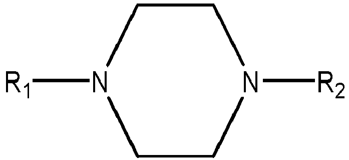 wherein R₁ and R₂ are independently selected from the group consisting of alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof.
#3. The tungsten chemical mechanical polishing (CMP) composition of #2, wherein the piperazine derivative is substituted organic mono-amino piperazine derivative (a) or substituted organic bis-amino piperazine derivative (b) having molecular structures of: 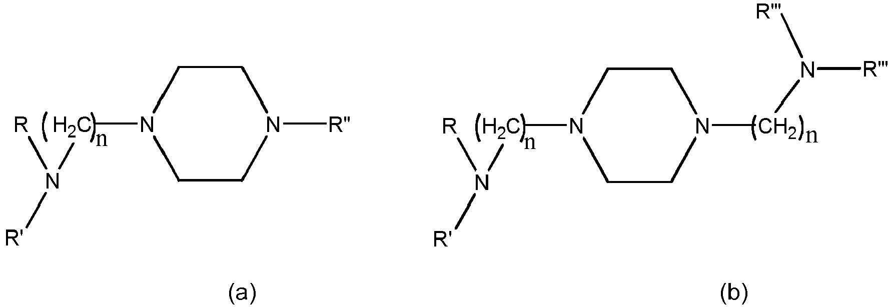 wherein
   organic amine function groups bounded to the nitrogen atoms at position 1 or 4 on 6-member ring of piperazines can be the same or different;
   n is from 1 to 6 representing different length of organic alkyl groups to bridge the nitrogen atom from piperazine ring and the nitrogen atom from the organic amine function groups; and
   the organic amine functional group is selected from the group consisting of primary amine group, H₂N-R-, secondary organic amine group, HRN-R'-, and tertiary organic amine group, RR'N-R"-;
   wherein R, R', R" and R'" are independently selected from the group consisting of proton, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof; and R, R R" and R'" can be the same or different.
#4. The tungsten chemical mechanical polishing (CMP) composition of #2, wherein the piperazine derivatives is selected from the group consisting of (R)-piperazine-2-carboxylic acid; 1-(2-Hydroxyethyl)piperazine; Piperazine-2,6-dione; 1-(2-Aminoethyl)piperazine; 1,4-Bis(2-hydroxyethyl)piperazine; 1,4-Bis(acryloyl)piperazine; Piperazine-1-acetic acid *tert*-butyl ester; 1-(3-Methylbenzyl)piperazine; 4-Boc-piperazine-2-carboxylic acid; 1-(Diphenylmethyl)piperazine; 1,4-Di-Boc-piperazine-2-carboxylic acid; 2-(piperazine-1-carbonyl)-benzoic acid; 4-(Piperazine-1-carbonyl)-piperidine-1-carboxylic acid *tert*-butyl ester; piperazine-1-carboxylic acid (2-chloro-phenyl)-amidepiperazine-1-carboxylic acid dimethylamide; piperazine-1-carboxylic acid diethylamide; piperazine-1-carboxylic acid diphenylamide; piperazine-1-sulfonamide; piperazine-2-carboxamide; 1,2-dimethyl-piperazine; 1-(2-butyl)-piperazine; 2-isobutyl-piperazine; 2-*tert*-butyl Piperazine; r-2-isobutyl-piperazine; s-2-isobutyl-piperazine; 2-isopropyl-piperazine; 1-(2-Pyrimidyl)piperazine; 1-(4-Trifluoromethylphenyl)piperazine; 1-(Cyclopropylmethyl)piperazine; 1-(2-pyrazinyl)-piperazine; 1-(2-trifluoromethylphenyl)-piperazine; 1-(6-Pyridazinyl)piperazine; 2-(4-trifluoromethylphenyl)piperazine; 2-phenylpiperazine-1-carboxylic acid benzyl ester; 1-(1-Naphthylmethyl)piperazine; 1-(1-pentyl)piperazine; 1-(2-pentyl)-piperazine; 1-(3-penty)-piperazine; 1-(propanoyl)-piperazine; 2-phenyl-piperazine-1-carboxylic acid *tert*-butyl ester; 1-Boc-piperazine; 1-(4-Chlorophenyl)piperazine; 1-(2-Furoyl)piperazine; 1-(2-Fluorophenyl)piperazine; 1-(2-Hydroxyphenyl)piperazine; 1-(2-Phenylethyl)piperazine; 1-(4-Fluorophenyl)piperazine; 1-(2-Methylbenzyl)piperazine; 1-(4-Hydroxyphenyl)piperazine; 1-(4-Methylbenzyl)piperazine; 1-(3-Hydroxyphenyl) piperazine; 1-(1-phenylethyl)piperazine; 1-(2,4-Dimethylphenyl)piperazine; 1-(2,5-Dimethylphenyl)piperazine; 1-(2,5-Dimethylphenyl)piperazine; 1-(2,6-xylyl)piperazine; 1-(2-ethylphenyl)piperazine; 1-(2-ethylphenyl)piperazine; 1-(3,4-dimethylphenyl)piperazine; 1-(3,5-Dimethylphenyl)piperazine; 1-(3-fluorophenyl)piperazine; 1-(3-furoyl)piperazine; 1-(N-heptyl)piperazine; 1-Pivaloyl-piperazine; 2,3-Dimethyl-piperazine-1-carboxylic acid *tert-*butyl ester; 2-(2-chlorophenyl)piperazine; 2-(4-chlorophenyl)piperazine; n-4-cbz-piperazine-2-carboxylate methyl ester; 1-(2-Pyridyl)piperazine; 1-(2-Methoxyphenyl)piperazine; 1-(4-Methoxyphenyl)piperazine; 1-(4-Chlorobenzhydryl)piperazine; 1-(4-Pyridyl)piperazine; 1-(4-Aminophenyl)piperazine; 1-(4-Methoxybenzyl)piperazine; 1-(2-Cyanophenyl)piperazine; 1-(1-Adamantyl)piperazine; 1-(4-Nitrophenyl)piperazine; 1-(2-Methoxyethyl)piperazine; 2-(Trifluoromethyl)piperazine; 1-(3,4-Dichlorophenyl)piperazine; 1-Boc-piperazine-2-carboxylic acid; 1-(2,5-Difluorobenzyl)piperazine; 1-(2-Ethoxyethyl)piperazine; 1-(3,4-Dichlorobenzyl)piperazine; 1-(3-Methoxyphenyl)piperazine; 1-(Cyclohexylmethyl)piperazine; 1-(3-Methylphenyl)piperazine; 1-(4-Methylphenyl)piperazine; 1-(3-Fluorobenzyl)piperazine; 1-(4-Fluorobenzyl)piperazine; 2-(3-Methoxyphenyl)piperazine; 1-(3-Chlorobenzyl)piperazine; 1-(Cyclopropylcarbonyl)piperazine; (*R*)-1-Boc-piperazine-2-carboxylic acid; (R)-2-benzyl-piperazine; (*R*)-3-Hydroxymethyl-piperazine-1-carboxylic acid *tert*-butyl ester; (*R*)-4-N-Boc-piperazine-2-carboxylic acid; S)-2-benzyl-piperazine; (*S*)-2-Benzyl-piperazine-1-carboxylic acid *tert*-butyl ester; (*S*)-3-Hydroxymethyl-piperazine-1-carboxylic acid *tert*-butyl ester; (*S*)-4-*N*-Boc-piperazine-2-carboxylic acid; 1-(1-Piperidinylsulfonyl)piperazine; 1-(2,2,2-trifluoroethyl)piperazine; 1-(2,3-Difluorophenyl)piperazine; 1-(2,4,6-Trimethylbenzyl)piperazine; 1-(2,4-Dichlorobenzyl)piperazine; 1-(2,4-Difluorophenyl)piperazine; 1-(2,6-Dichlorobenzyl)piperazine; 1-(2-Chlorobenzyl)piperazine; 1-(2-Cyclohexylethyl)piperazine; 1-(2-diisopropylaminoethyl)piperazine; 1-(2-Dipropylaminoethyl)-piperazine; 1-(2-Ethoxyphenyl)piperazine; 1-(2-ethylbutanoyl)piperazine; 1-(2-Fluorobenzyl)piperazine; 1-(2-Isopropoxyethyl)piperazine; 1-(2-methylmercaptophenyl)piperazine; 1-(2-methylpropanoyl)-piperazine; 1-(2-morpholinoethyl)piperazine; 1-(2-Phenoxyethyl)piperazine; 1-(2-piperidinoethyl)piperazine; 1-(2-pyrrolidinoethyl)piperazine; 1-(3,3-dimethylbutanoyl)piperazine; 1-(3,4-dichlorobenzoyl)piperazine; 1-(31-(3,5-dichlorophenyl)piperazine; 4-difluorobenzoyl)piperazine; 1-(3,4-dimethylbenzyl)piperazine; 1-(3,5-dimethoxybenzoyl)piperazine; 1-(3,5-dimethylbenzoyl)piperazine; 1-(3-aminopropyl)piperazine; 1-(3-cyanopropyl)piperazine; 1-(3-diethylaminopropyl)piperazine; 1-(3-dipropylaminopropyl)-piperazine; 1-(3-methoxypropyl)-piperazine; 1-(3-morpholinopropyl)piperazine; 1-(3-Phenylpropyl)piperazine; 1-(3-piperidinopropyl)piperazine; 1-(3-pyrrolidinopropyl)piperazine; 1-(4-chlorobenzoyl)piperazine; 1-(4-Chlorobenzyl)piperazine; 1-(4-ethoxyphenyl)piperazine; 1-(4-methoxybenzoyl)-piperazine; 1-(4-methoxybutyl)piperazine; 1-(4-phenylbutyl)-piperazine; 1-(4-pyridylmethyl)piperazine; 1-(4-*tert*-Butylbenzyl)piperazine; 1-(Cyclohexylcarbonyl)piperazine; 1-(Ethanesulfonyl)piperazine; 1-(phenylacetyl)piperazine; 1-cbz-piperazine-2-carboxylic acid; 1-hexanoyl-piperazine; 1-methylsulfonyl-piperazine; 2,3-diphenyl-piperazine; 2-(2-Furyl)piperazine; 2-(2-Methoxyphenyl)piperazine; 2-(2-Thienyl)piperazine; 2-(3-oxo-piperazine-1-carbonyl)-benzoic acid; 2-(4-Chlorophenyl)piperazine-1-carboxylic acid *tert*-butyl ester; 2-(4-Methoxyphenyl)piperazine; 2-(4-methylphenyl)piperazine; 2-benzyl-piperazine; 3-(4-Chlorophenyl)piperazine-1-carboxylic acid *tert*-butyl ester; 3-oxo-piperazine-2-carboxylic acid; 3-phenyl-piperazine-1-carboxylic acid ethyl ester; 4-(4-Boc-piperazine-1-carbonyl)phenylboronic acid pinacol ester; [5-(4-methyl-piperazine-1-sulfonyl)-pyridin-2-yl]-hydrazine; methyl piperazine-1-carboxylate; 1-ethyl-2-methyl-piperazine; 1,4-Bis(3-aminopropyl)piperazine; 1-[2-(2-Hydroxyethoxy)ethyl]piperazine; 1-(2-methyl-allyl)-piperazine; 2-(3-trifluoromethyl-phenyl)-piperazine; 4-N-Boc-2-methyl-piperazine;-(tetrahydro-2-furoyl)-piperazine; 1-(Tetrahydro-2-furylmethyl)piperazine; (*R*)-1-Boc-2-ethyl-piperazine; (*R*)-1-Boc-3-ethyl-piperazine; (*S*)-1-Boc-2-ethyl-piperazine; (*S*)-1-Boc-3-ethyl-piperazine; 1-[1-(2-methoxyphenyl)ethyl]piperazine; 1-[1-(3-methoxyphenyl)ethyl]piperazine; 1-[1-(4-methoxyphenyl)-ethyl]-piperazine; 1-[2-(2-Methylphenoxy)ethyl]piperazine; 1-(4-ethoxy-benzyl)-piperazine; 1-Boc-2,6-dimethyl-piperazine; 1-Boc-3,3-dimethyl-piperazine; 1-Boc-3,5-dimethyl-piperazine; 1-Boc-5-oxo-piperazine-2-carboxylic acid; 1-*N*-(*tert*-Butoxycarbonyl)-2-ethyl-piperazine; 2-(2-fluorophenyl)-piperazine; 2-(3-fluoro-phenyl)-piperazine; 2-methyl-1-(3-methylphenyl)piperazine; 4-(5-Aminopyridin-2-yl)piperazine-1-carboxylic acid *tert*-butyl ester; 1-[2-(Dimethylamino)ethyl]piperazine; 1-(1-Methyl-4-piperidinyl)piperazine; 1-Acetyl-4-(4-hydroxyphenyl)piperazine; 1-[4-(Trifluoromethyl)benzyl]piperazine; 1-Boc-4-(2-formylphenyl)piperazine; 1-Amino-4-(2-hydroxyethyl)piperazine; 1-Boc-(4-benzyl)piperazine; 1-Boc-4-[3-(ethoxycarbonyl)phenyl]piperazine; 1-Bis(4-fluorophenyl)methyl piperazine; 1-Boc-4-(3-hydroxypropyl)piperazine; 1-Boc-4-(4-formylphenyl)piperazine; 1-Boc-4-(4-methoxycarbonylphenyl)piperazine; 1-(1,3-Dioxolan-2-ylmethyl)piperazine; 1-(3-Aminopropyl)-4-(2-methoxyphenyl)piperazine; 1-[3-(Dimethylamino)propyl]piperazine; 1-(1,2,3,4-Tetrahydronaphthalen-2-yl)piperazine; 1-(4-Aminobutyl)-4-(2-methoxyphenyl)piperazine; 1-Boc-4-(2-methoxycarbonylphenyl)piperazine; 1-Boc-4-(5-nitro-2-pyridyl)piperazine; (*R*)-1-Boc-2-benzyl-piperazine; (*R*)-1-*N*-Boc-2-isopropyl piperazine; (*R*)-1-*N*-Boc-4-*N*-Fmoc-2-piperazine carboxylic acid; (R)-1-N-cbz-2-methyl-piperazine; (R)-4-N-trityl-2-methyl piperazine; (R)-N4-benzyl-2-(benzyloxymethyl)piperazine; (*S*)-1-Boc-2-hydroxymethyl-piperazine; (S)-1-Boc-2-isobutyl-piperazine; (S)-1-Boc-3-benzyl-piperazine; (S)-1-Boc-3-isopropyl-piperazine; (*S*)-1-*N*-Boc-4-*N*-Fmoc-piperazine-2-carboxylic acid; (S)-4-N-trityl-2-methyl-piperazine; (S)-n4-benzyl-2-(methylthioethyl)piperazine; 1-[(2,6-dichlorophenyl)sulfonyl]piperazine; 1-[(2-Methyl-1,3-thiazol-5-yl)methyl]piperazine; 1-[(4,5-Dimethyl-1,3-oxazol-2-yl)methyl]piperazine; 1-[(4-cyclohexylphenyl)sulfonyl]piperazine; 1-[(4-Isobutylphenyl)sulfonyl]piperazine; 1-[(4-Methyl-1,2,5-oxadiazol-3-yl)methyl]piperazine; 1-[(4-sec-Butylphenyl)sulfonyl]piperazine; 1-[(4-*tert-*Butyl-2,6-dimethylphenyl)sulfonyl]piperazine; 1-[1-(pyridin-2-yl)ethyl]piperazine; 1-[1-(pyridin-3-yl)ethyl]piperazine; 1-[1-(thiophen-2-yl)ethyl]piperazine; 1-[2-(1-propyl)-oxyethyl]-piperazine; 1-[2-(1*H*-Pyrrol-1-yl)ethyl]piperazine; 1-[2-(2-methoxy-phenoxy)-ethyl]-piperazine; 1-[2-(diallylamino)-ethyl]-piperazine; 1-[2-(trifluoromethyl)pyridin-4-yl]piperazine; 1-[2-(trifluoromethyl)quinol-4-yl]piperazine; 1-[2-Fluoro-4-(methylsulfonyl)phenyl]piperazine; 1-[2-Fluoro-4-(methylsulphonyl)phenyl]-4-(2-hydroxyethyl)piperazine; 1-[3-(1-Piperidinylcarbonyl)-2-pyridinyl]piperazine; 1-[3-(difluoromethoxy)benzoyl]piperazine; 1-[3-(trifluoromethyl)pyrid-2-yl]piperazine; 1-[4-(methylsulfonyl)phenyl]piperazine; 1-[4-(trifluoromethyl)pyrimid-2-yl]piperazine; 1-(1H-Imidazol-2-ylmethyl)piperazine; 1-(2,6-Dimethylpyridin-4-yl)piperazine; 1-(2-benzhydryloxy-ethyl)-piperazine; 1-(2-hydroxyethyl)-4-isopropyl-piperazine; 1-(2-imidazol-1-yl-ethyl)-piperazine; 1-(2-isocyano-ethyl)-4-methyl-piperazine; 1-(2-Methyl-thiazol-4-ylmethyl)-piperazine; 1-(2-*N*-Boc-aminoethyl)piperazine; 1-(2-pyridin-2-yl-ethyl)-piperazine; 1-(2-pyridin-4-yl-ethyl)-piperazine; 1-(2-thiophen-2-yl-ethyl)piperazine; 1-(3,5-dimethyl-isoxazol-4-ylmethyl)-piperazine; 1-(3-methoxy-benzyl)-piperazine; 1-(3-methylbenzoyl)-piperazine; 1-(3-methyl-pyridin-2-ylmethyl)-piperazine; 1-(3-Methylpyridin-2-yl)piperazine; 1-(3-methylpyridin-4-yl)piperazine; 1-(4,6-dimethylpyrimidin-2-yl)piperazine; 1-(4-cyano-benzyl)-piperazine; 1-(4-ethoxy-benzenesulfonyl)-piperazine; 1-(4-Ethoxy-pyridin-2-yl)-piperazine; 1-(4-Fluorobenzyl)-4-(2-hydroxyethyl)piperazine; 1-(4-Hydroxy-phenyl)-piperazine-4-carboxylic acid *tert*-butyl ester; (on page 14 now) *N-*Boc-piperidine; 2-Methylpiperazine; 2,6-Dimethylpiperazine; *trans*-2,5-Dimethylpiperazine; 1,4-Dimethylpiperazine; (*R*)-1-Boc-3-methylpiperazine; 1-Boc-3-oxopiperazine; 1,4-BIS-(2-METHOXY-5-METHYL-BENZENESULFONYL)-2-METHYL-PIPERAZINE; 1-[(1-METHYL-1H-PYRAZOL-3-YL)CARBONYL]PIPERAZINE; 1-[(1-METHYL-1 H-PYRAZOL-4-YL)METHYL]PIPERAZINE; 1-(2-(N,N-BIS-(2-HYDROXYPROPYL)-AMINO)-ETHYL)-4-(2-HYDROXYPROPYL)-PIPERAZINE; 1-(2-METHOXYPHENYL)-4-((4-(2-METHOXYPHENYL)-1-PIPERAZINYL)(OXO)ACETYL)PIPERAZINE; 1-(3-(2,3-DIHYDRO-1,4-BENZODIOXIN-6-YL)ACRYLOYL)-4-(4-FLUOROPHENYL)PIPERAZINE; 1-(4-CHLOROPHENYL)-4-[(7-{[4-(4-CHLOROPHENYL)-1-PIPERAZINYL]SULFONYL}-9H-FLUOREN-2-YL)SULFONYL]PIPERAZINE; 1-(4-FLUOROPHENYL)-4-((4-(4-FLUOROPHENYL)-1-PIPERAZINYL)(OXO)ACETYL)PIPERAZINE; 1-(4-NITROPHENYL)-4-(3-{[4-(4-NITROPHENYL)-1-PIPERAZINYL]CARBONYL}BENZOYL)PIPERAZINE; 1-(4-NITROPHENYL)-4-(4-{[4-(4-NITROPHENYL)-1-PIPERAZINYL]CARBONYL}BENZOYL)PIPERAZINE; 1-ACETYL-4-(1-ETHYL-1H-IMIDAZOL-2-YL)PIPERAZINE; 1-BENZHYDRYL-4-{2-[5-(BENZYLSULFANYL)-4-(2-METHYL-2-PROPENYL)-4H-1,2,4-TRIAZOL-3-YL]ETHYL}PIPERAZINE; 1-BENZYL-4-[2-[(2',4'-DIFLUORO[1,1'-BIPHENYL]-4-YL)OXY]ETHYL]PIPERAZINE; 1-BENZYL-4-(3-((2',4'-DIFLUORO(1,1'-BIPHENYL)-4-YL)OXY)PROPYL)PIPERAZINE; 1-ISOPROPYL-4-[(1-METHYL-1 H-PYRROL-2-YL)METHYL]PIPERAZINE; 1-METHYL-4-({7-[(4-METHYL-1-PIPERAZINYL)SULFONYL]-9H-FLUOREN-2-YL}SULFONYL)PIPERAZINE; 1-phenyl-4-[phenyl(4-phenyl-1-piperazinyl)methyl]piperazine; 1-methyl-4-(methylsulfonyl)piperazine; 4-(2-HYDROXY-ETHYL)-PIPERAZINE-1-CARBOXYLIC ACID (4-ISOPROPYL-PHENYL)-AMIDE; 6-HYDROXYMETHYL-1,3-DIMETHYL-PIPERAZINE-2,5-DIONE; BIS(2-METHOXYPHENYL) 2,2'-(PIPERAZINE-1,4-DIYL)DIETHANESULFONATE; 1-(ADAMANTANE-1-SULFINYL)-4-METHYL-PIPERAZINE; 1-(PHENYLSULFONYL)-4-(2-PYRIDINYL)PIPERAZINE; 1-BENZYL-4-(2-METHOXYPROPANOYL)PIPERAZINE; 1-CYCLOHEXYL-4-(METHYLSULFONYL)PIPERAZINE; 1-ETHYL-4-(3-FURYLMETHYL)PIPERAZINE; 1-(3-phenoxy-4-pyridinyl)piperazine; 1-(2-PYRIDINYL)-4-(3-(2,3,4-TRIMETHOXYPHENYL)ACRYLOYL)PIPERAZINE; 1-(3-(1,3-BENZODIOXOL-5-YL)ACRYLOYL)-4-(2-PYRIDINYL)PIPERAZINE; 1-(3-(1,3-BENZODIOXOL-5-YL)ACRYLOYL)-4-(4-METHOXYPHENYL)PIPERAZINE; 1,4-BIS-(2-PYRIDYLMETHYLENEAMINO)-PIPERAZINE; 1,4-BIS-(3,4,5-TRIMETHOXYBENZYLIDENEAMINO-PIPERAZINE; 1,4-BIS-(ACETOACETYL)-PIPERAZINE; 1,4-di(2-furoyl)piperazine; 1,4-bis[2-(4-pyridinyl)ethyl]piperazine; 1,4-BIS(2-(2-PYRIDINYL)ETHYL)PIPERAZINE; 1,4-BIS(2-CARBOXYBENZOYL)PIPERAZINE; 1,4-bis(3-pyridinylmethyl)piperazine; 1-(ETHOXYCARBONYLMETHYL)PIPERAZINE; 2,3,5,6-TETRAHYDROXY-PIPERAZINE-1,4-DICARBALDEHYDE; 4-BENZYL-PIPERAZINE-1-CARBOXYLIC ACID CYCLOHEXYLAMIDE; diethyl 2,2'-(piperazine-1,4-diyl)bis(2-oxoacetate); diethyl 2,2'-(piperazine-1,4-diyl)diacetate; dimethyl 3,3'-(piperazine-1,4-diyl)dipropanoate; (2E,2'E)-3,3'-(piperazine-1,4-diyl)bis(1-(2-hydroxyphenyl)prop-2-en-1-one); 2,2'-(PIPERAZINE-1,4-DIYL)BIS(N-(1,5-DIMETHYL-3-OXO-2-PHENYL-2,3-DIHYDRO-1 H-PYRAZOL-4-YL)ACETAMIDE); 2,2'-(piperazine-1,4-diyl)dipropanamide; 2,2'-(piperazine-1,4-diyl)dipropanenitrile; 3,3'-(PIPERAZINE-1,4-DIYL)BIS(1-(9H-CARBAZOL-9-YL)PROPAN-2-OL) FUMARATE; 3,3'-(piperazine-1,4-diyl)bis(1-phenylpropan-1-one); 3,3'-(piperazine-1,4-diyl)dipropan-1-ol; 4,4'-(piperazine-1,4-diyl)bis(3-ethoxycyclobut-3-ene-1,2-dione; PIPERAZINE-1,4-DICARBOTHIOIC ACID BIS-PHENYLAMIDE; 1,4-DI-TERT-BUTYL-PIPERAZINE-2,5-DIONE; 1,4-DIDODECYL-PIPERAZINE; 1,4-DIHEXADECYL-PIPERAZINE; 1-(1-PIPERIDINYLCARBONYL)PIPERAZINE; 1-(1-ADAMANTYLMETHYL)PIPERAZINE; 1-(3,4-dimethoxybenzyl)piperazine; 1-(3-PYRIDINYLCARBONYL)PIPERAZINE; 4-Piperazinobenzonitrile; (S)-3-Methyl-2-ketopiperazine; (R)-3-Methyl-2-ketopiperazine; 4-(Boc-piperazin-1-yl)-3-nitrobenzoic acid; 1,1'-(piperazine-1,4-diyl)dipropan-2-ol; 2,2'-(piperazine-1,4-diyl)bis(1-phenylethanol); 2,2'-(piperazine-1,4-diyl)bis(2-methylpropanenitrile); Piperazine-N,N'-bis(2-ethanesulfonic acid); 1-Formylpiperazine; PIPES sodium salt; PIPES disodium salt; PIPES dipotassium salt; Piperazine-N,N'-bis(2-hydroxypropanesulfonic acid); Ethyl 1-piperazinecarboxylate; POPSO disodium salt; 4-Hydroxy-3-methoxyphenylglycol hemipiperazinium salt; Citric acid sesquipiperazine salt hydrate; 4-(2-Hydroxyethyl)piperazine-1-ethanesulfonic acid; 4-(2-Hydroxyethyl)-1-piperazinepropanesulfonic acid; HEPES sodium salt; N-(2-Hydroxyethyl)piperazine-N'-(4-butanesulfonic acid); 3-Methyl-2-ketopiperazine; HEPES potassium salt; 3-Piperazinopropionitrile; Ethyl piperazinoacetate; Estropipate; 1-Piperazinepropanol; t-butyl-4-(2-Amino-1-phenylethyl)piperazine carboxylate; *tert-*Butyl 4-[2-(aminomethyl)phenyl]piperazine-1-carboxylate; *tert-*Butyl 4-[5-(hydroxymethyl)pyrid-2-yl]piperazine-1-carboxylate; *tert-*Butyl 4-(3-aminobenzyl)piperazine-1-carboxylate; *tert-*Butyl 4-(4-[(methylamino)methyl]phenyl)piperazine-1-carboxylate; *tert-*Butyl 4-(4-cyanopyrid-2-yl)piperazine-1-carboxylate; *tert-*Butyl 4-(5-formylpyrid-2-yl)piperazine-1-carboxylate; tert-Butyl 4-(oxetan-3-yl)piperazine-1-carboxylate; *tert-*Butyl 4-(piperidin-3-yl)piperazine-1-carboxylate; *tert-*Butyl 4-(pyrrolidin-2-ylcarbonyl)piperazine-1-carboxylate; tert-Butyl 4-(1 H-pyrrolo[2,3-b]pyridin-4-yl)piperazine-1-carboxylate; 1-[2-(2,5-dimethyl-1 H-pyrrol-1-yl)ethyl]piperazine; 1-((1,5-dimethyl-1 H-pyrazol-4-yl)methyl)piperazine; 1-(1-Ethyl-5-methyl-1*H*-pyrazol-4-ylmethyl)-piperazine; t-butyl4-(2-Amino-1-[4-(trifluoromethyl)phenyl]ethyl)piperazine carboxylate; 3-(4-Fluoro-phenyl)-piperazine-1-carboxylic acid *tert*-butyl ester; 3-(4-Hydroxy-phenyl)-piperazine-1-carboxylic acid *tert-*butyl ester; 3-Furan-2-yl-piperazine-1-carboxylic acid *tert*-butyl ester; 3-thiophen-2-yl-piperazine-1-carboxylic acid benzyl ester; 4-(2-Amino-phenyl)-piperazine-1-carboxylic acid *tert*-butyl ester; 4-(2-Aminoethyl)-1-boc-piperazine; 4-(5-Carboxy-pyridin-2-yl)-2-methyl-piperazine-1-carboxylic acid *tert*-butyl ester; 4-Boc-1-(6-methyl-2-pyridyl)piperazine; Fmoc-4-carboxymethyl-piperazine; Methyl 4-Boc-piperazine-2-carboxylate; N,N-dimethyl-1-piperazine sulfonamide; *N*-1-Boc-*N*-4-Fmoc-2-Piperazine carboxylic acid; *N*-4-Boc-*N*-1-cbz-2-piperazine carboxylic acid; *N*-4-Boc-*N*-1-Fmoc-2-Piperazine acetic acid; sulfuric acid compound with piperazine-1-carboximidamide (1:1); 1-ethyl-4-piperidin-4-yl-piperazine; 1-furan-2-ylmethyl-piperazine; 1-methyl-4-(2-piperidin-4-yl-ethyl)-piperazine; 1-Methyl-4-(6-aminopyridin-3-yl)piperazine; 1-methyl-4-(piperidin-4-yl)-piperazine; 1-*N*-Boc-4-(azetidin-3-yl)piperazine; 1-pyridin-2-ylmethyl-piperazine; 1-Pyridin-3-ylmethyl-piperazine; 1-thiazol-2-yl-piperazine; 2-(2,5-dimethoxy-phenyl)-piperazine; 2-Carboxymethyl-3-oxo-piperazine-1-carboxylic acid *tert*-butyl ester; 2-Ethoxycarbonylmethyl-3-oxo-piperazine-1-carboxylic acid *tert-butyl* ester; 1-(4-methylcyclohexyl)-piperazine; 1-(4-methyl-piperidine-1-sulfonyl)-piperazine; 1-(4-trifluoromethyl-pyridin-2-yl)-piperazine; 1-(5-Methyl-2-pyridinyl)piperazine; 1-(5-Methyl-2-thiazolyl)-piperazine; 1-(5-Nitropyridin-2-yl)piperazine; 1-(6-Butoxy-2-pyridinyl)piperazine; 1-(6-methylpyrid-2-yl)piperazine; 1-(N-Methylpiperidin-3-yl-methyl)piperazine; 1-(thien-2-ylacetyl)piperazine; 1-Boc-4-(piperidin-4-yl)-piperazine; 1-Boc-4-cyanomethyl piperazine; 1-cyclohex-3-enylmethyl-piperazine, and combinations thereof.
#5. The tungsten chemical mechanical polishing (CMP) composition of #2, wherein the piperazine derivatives is selected from the group consisting of mono-substituted 1-(2-aminoethyl) piperazine, bis-substituted 1, 4-Bis (3-aminopropyl) piperazine, and combinations thereof.
#6. The tungsten chemical mechanical polishing (CMP) composition of #1, wherein the chemical additive is salt of cyanate selected from the group consisting of potassium cyanate, sodium cyanate, ammonium cyanate, tetraalkylammonium cyanate, and combinations thereof.
#7. The tungsten chemical mechanical polishing (CMP) composition of #1, further comprising one or more of
   a corrosion inhibitor;
   a pH buffering agent;
   a surfactant; and
   a biocide when pH of the polishing composition is between 5.0 to 8.0.
#8. A process of selective chemical mechanical polishing, comprising steps of:
   a) providing a semiconductor substrate having a surface containing tungsten and at least one other material;
   b) providing a polishing pad;
   c) providing a chemical mechanical polishing (CMP) composition comprising
      1) 0.1 wt% to 25 wt% nano-sized abrasive selected from the group consisting of silica, alumina, ceria, titania, zirconia, and combinations thereof;
      2) 0.1 wt% to 0.5wt% solid catalyst of iron compounds coated particles selected from the group consisting of iron compounds coated colloidal silica, colloidal or nano-sized inorganic metal oxide particles and combinations thereof;
      3) 0.0001 wt% to 0.5 wt% chemical additive selected from the groups consisting of piperazine derivatives, salts of cyanate, and combinations thereof;
      4) 0.5 wt% to 10 wt% oxidizer and
      5) remaining is liquid carrier;
         wherein pH of the CMP composition is from about 2.0 to about 8;
   c) contacting the surface of the semiconductor substrate with the polishing pad and the chemical mechanical polishing composition; and
   d) polishing the surface of the semiconductor substrate;
      wherein at least a portion of the surface containing tungsten is in contact with both the polishing pad and the chemical mechanical polishing composition; and ratio of removal rate of tungsten to removal rate of the at least one other material is equal or greater than 1.
#9. The process of chemical mechanical polishing tungsten containing semiconductor substrate of #8, wherein the chemical additive is piperazine derivative having a general molecular structure of: 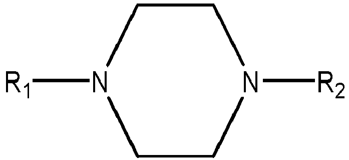 wherein R₁ and R₂ are independently selected from the group consisting of alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof.
#10. The process of chemical mechanical polishing tungsten containing semiconductor substrate of #8, wherein the piperazine derivative is (a) substituted organic mono-amino piperazine derivative or (b) substituted organic bis-amino piperazine derivative; having molecular structures of: 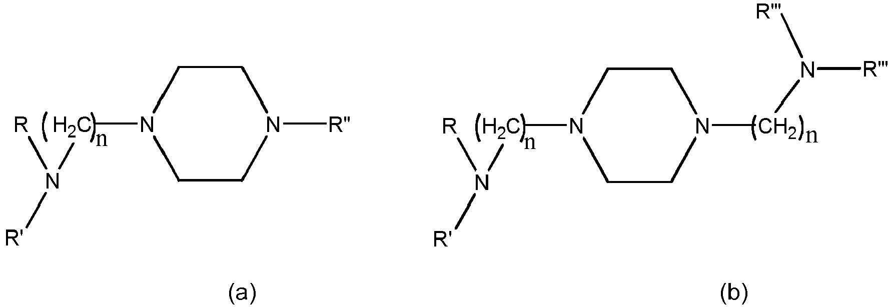 wherein
   organic amine function groups bounded to the nitrogen atoms at position 1 or 4 on 6-member ring of piperazines can be the same or different;
   n is from 1 to 6 representing different length of organic alkyl groups to bridge the nitrogen atom from piperazine ring and the nitrogen atom from the organic amine function groups; and
   the organic amine functional group is selected from the group consisting of primary amine group, H₂N-R-, secondary organic amine group, HRN-R'-, and tertiary organic amine group, RR'N-R"-;
   wherein R, R', R" and R'" are independently selected from the group consisting of proton, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof; and R, R', R" and R'" can be the same or different.
#11. The process of chemical mechanical polishing tungsten containing semiconductor substrate of #9, wherein the chemical additive is piperazine derivative selected from the group listed in #4 above.
#12. The process of chemical mechanical polishing tungsten containing semiconductor substrate of #9, wherein the chemical additive is piperazine derivative selected from the group consisting of mono-substituted 1-(2-aminoethyl) piperazine, bis-substituted 1, 4-Bis (3-aminopropyl) piperazine, and combinations thereof.
#13. The process of chemical mechanical polishing tungsten containing semiconductor substrate of #9, wherein the chemical additive is salt of cyanate selected from the group consisting of potassium cyanate, sodium cyanate, ammonium cyanate, tetraalkylammonium cyanate, and combinations thereof.
#14. The process of chemical mechanical polishing tungsten containing semiconductor substrate of #9, wherein the chemical mechanical polishing (CMP) composition further comprising one or more of
   a corrosion inhibitor
   a pH buffering agent;
   a surfactant; and
   a biocide when pH of the polishing composition is between 5.0 to 8.0.
#15. A system of selective chemical mechanical polishing comprising:
   a) a semiconductor substrate having a surface containing tungsten and at least one other material;
   b) a polishing pad;
   c) a chemical mechanical polishing (CMP) composition comprising
      1) 0.1 wt% to 25 wt% nano-sized abrasive selected from the group consisting of silica, alumina, ceria, titania, zirconia, and combinations thereof;
      2) 0.1 wt% to 0.5wt% solid catalyst of iron compounds coated particles selected from the group consisting of iron compounds coated colloidal silica, colloidal or nano-sized inorganic metal oxide particles and combinations thereof;
      3) 0.0001 wt% to 0.5 wt% chemical additive selected from the groups consisting of piperazine derivatives, salts of cyanate, and combinations thereof;
      4) 0.5 wt% to 10 wt% oxidizer and
      5) remaining is liquid carrier;
         wherein pH of the CMP composition is from about 2.0 to about 8;
         wherein at least a portion of the surface containing tungsten is in contact with both the polishing pad and the chemical mechanical polishing composition.
#16. The system of selective chemical mechanical polishing of #15, wherein
   the chemical additive is piperazine derivative having a general molecular structure of: 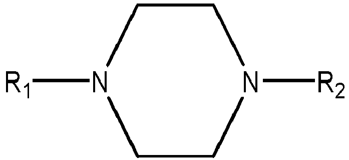 wherein R₁ and R₂ are independently selected from the group consisting of alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof.
#17. The system of selective chemical mechanical polishing of #16, wherein the piperazine derivative is substituted organic mono-amino piperazine derivative (a) or substituted organic bis-amino piperazine derivative (b) having molecular structures of: 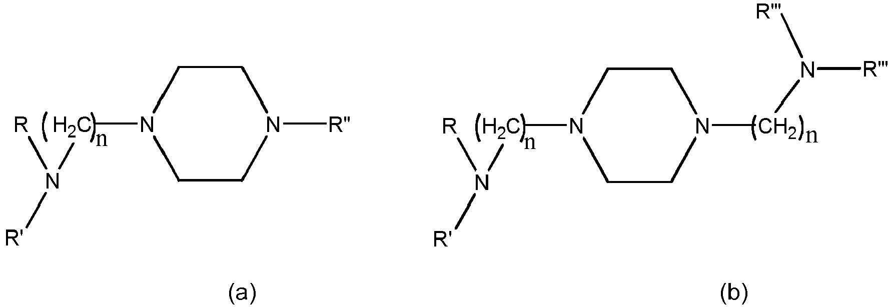 wherein
   organic amine function groups bounded to the nitrogen atoms at position 1 or 4 on 6-member ring of piperazines can be the same or different;
   n is from 1 to 6 representing different length of organic alkyl groups to bridge the nitrogen atom from piperazine ring and the nitrogen atom from the organic amine function groups; and
   the organic amine functional group is selected from the group consisting of primary amine group, H₂N-R-, secondary organic amine group, HRN-R'-, and tertiary organic amine group, RR'N-R"-;
   wherein R, R', R" and R'" are independently selected from the group consisting of proton, alkyl, alkoxy, organic group with one or more hydroxyl groups, substituted organic sulfonic acid, substituted organic sulfonic acid salt, substituted organic carboxylic acid, substituted organic carboxylic acid salt, organic carboxylic ester, organic amine, and combinations thereof; and R, R', R" and R'" can be the same or different.
#18. The system of selective chemical mechanical polishing of #15, wherein the chemical additive is piperazine derivative selected from the group listed in #4 above.
#19. The system of selective chemical mechanical polishing of #15, wherein the chemical additive is piperazine derivative selected from the group consisting of mono-substituted 1-(2-aminoethyl) piperazine, bis-substituted 1, 4-Bis (3-aminopropyl) piperazine, and combinations thereof.
#20. The system of selective chemical mechanical polishing of #15, wherein the chemical additive is salt of cyanate selected from the group consisting of potassium cyanate, sodium cyanate, ammonium cyanate, tetraalkylammonium cyanate, and combinations thereof.
#21. The system of selective chemical mechanical polishing of #15, wherein the chemical mechanical polishing (CMP) composition further comprising one or more of
   a corrosion inhibitor
   a pH buffering agent;
   a surfactant; and
   a biocide when pH of the polishing composition is between 5.0 to 8.0.

Features described in connection with any aspect of the invention can be used in connection with any other aspect of the invention.

### DETAILED DESCRIPTION OF THE INVENTION

Tungsten slurry compositions disclosed herein suitably mainly comprise nano-sized abrasives, solid catalyst on colloidal silica particle surfaces, and selected suitable chemical additives, a selected suitable oxidizing agent, and remainder substantially liquid carrier.

The chemical mechanical polishing (CMP) composition optionally further comprises one or more of the following:
a corrosion inhibitor;
a pH buffering agent;
a surfactant; and
a biocide when pH of the polishing composition is between 5.0 to 8.0.

Nano-sized abrasive particles used for the tungsten CMP polishing compositions disclosed herein include, but are not limited to, the following: colloidal silica with narrow or broad particle size distributions, with various sizes and with various shapes (the various shapes of the abrasives include spherical shape, cocoon shape, aggregate shape and other shapes), colloidal silica particles doped by other metal oxide within lattice of the colloidal silica, such as alumina doped silica particles, colloidal aluminum oxide, which includes alpha-, beta-, and gamma-types of aluminum oxides, colloidal and photoactive titanium dioxide, cerium oxide, colloidal cerium oxide, nano-sized diamond particles, nano-sized silicon nitride particles, mono-modal, bi-modal, multi-modal colloidal abrasive particles, zirconium oxide, organic polymer-based soft abrasives, surface-coated or modified abrasives, and mixtures thereof.

The mean particle size of abrasive particles used for the tungsten CMP polishing compositions disclosed herein is preferably in the range of 5 nm to 500 nm, more preferably in the range of 15 nm to 250 nm, and most preferably in the range of 25 nm to 150 nm. Mean particle size can be measured for example by dynamic light scattering technology.

The tungsten CMP polishing compositions of this invention contain 0.1 wt% to 25 wt% abrasives; preferably, from 0.5 wt% to 5 wt%.

Typically, the solid catalyst is iron compounds coated particles. Ferric oxide is a preferred iron compound. The particles suitably used for the preparation of the solid catalyst include colloidal silica and other types of colloidal or nano-sized inorganic metal oxide particles. An example of solid catalyst is ferric oxide coated on colloidal silica. Examples of suitable ferric oxide coated colloidal silica particles for use as the solid catalyst are disclosed in United States patents US7014669, US7029508 and US7427305.

The CMP slurry of this invention contains the solid catalyst ranging 0.01 wt% to 10 wt%; preferably ranging from 0.1 wt% to 0.5 wt%.

There are two types of chemical additives.

The first type of the selected chemical additives provides the polishing compositions with low static etching rates on tungsten films. Reducing static etching rates provides better corrosion protection on tungsten metal film surfaces, as well as reducing the dishing, erosion and plug recess while polishing tungsten or tungsten-containing substrates. By lowering static etching rates, the chemical additives are considered as corrosion inhibitor for tungsten metal surfaces corrosion protection.

The second type of chemical additives used in the tungsten polishing compositions not only behaves as corrosion inhibitors to lower the static etching rates on tungsten metal film surfaces providing better W metal surface corrosion protection, but also boosts the tungsten film removal rates. The second type chemical additives in tungsten polishing compositions disclosed herein are dual functional chemical additives.

In addition, the removal rate on polishing dielectric films is preferably not affected while the tungsten film removal rate is boosted. Thus, the selectivity of polishing tungsten/dielectric (W/D) films can be increased to afford tungsten CMP polishing slurries with higher selectivity of polishing W/D films. The tungsten chemical mechanical polishing compositions containing second type of chemical additives can provide better corrosion protection on tungsten film surfaces and higher selectivity of polishing W/D films to meet the various needs in semiconductor industry.

Both the first and the second chemical additives can deliver tunable removal rate and tunable selectivity of polishing W/D films.

The selected and suitable first type of chemical additives as corrosion inhibitors used for the disclosed tungsten CMP slurry include, but are not limited to, the following: piperazine and its derivatives.

The general molecular structure for some preferred piperazine derivatives is: 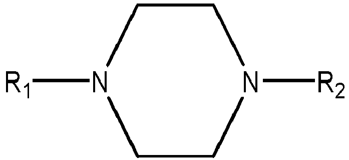 wherein R₁ and R₂ are independently selected from hydrogen, optionally substituted alkyl, optionally substituted aryl, optionally substituted aralkyl, optionally substituted alkoxy, optionally substituted organic group with one or more hydroxyl groups, optionally substituted organic sulfonic acid (-RSO₃H), optionally substituted organic sulfonic acid salt, optionally substituted keto, optionally substituted organic carboxylic acid (-RCO₂H), optionally substituted organic carboxylic acid salt (-RCOOM), optionally substituted organic carboxylic ester (-RCOOR'), optionally substituted organic amine (e.g. -RNH₂), optionally substituted organic amide, and combinations thereof; the organic amine based piperazine derivatives are considered important chemical additives to be used as corrosion inhibitors in the tungsten chemical mechanical polishing compositions disclosed herein.

R and R' can be for example, hydrocarbon side chains/linking groups, and M can be, for example, sodium, ammonium, or potassium. Possible substituents include fluoro and chloro.

In some preferred embodiments, R₁ is an organic amine group which is an alkylamino group, preferably a linear alkylamino group, more preferably a primary alkylamino group. Examples are 2-aminoethyl and 3-aminopropyl. In such embodiments R₂ is suitably hydrogen or the same group as R₁.

Specifically, suitable piperazines and its derivatives include: (a) substituted organic mono-amino piperazine derivatives and (b) substituted organic bis-amino piperazine derivatives having molecular structures as following:

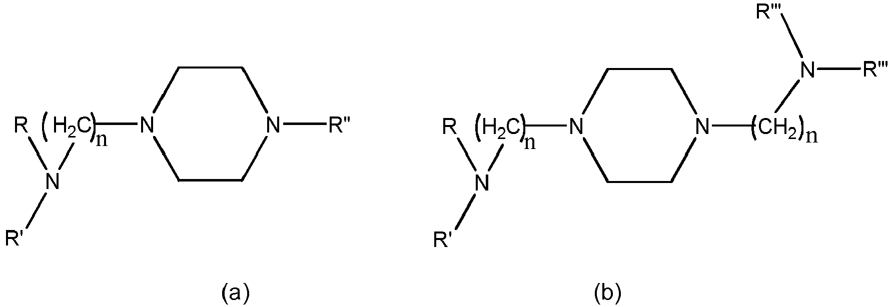

As shown in (a), the mono-substituted organic amine compounds with suitable organic amine function groups are bound to the nitrogen atoms at position 1 or 4 on 6-member ring of piperazine.

As shown in (b), the bis-substituted organic amine compounds with suitable organic amine function groups bounded to the nitrogen atoms at positions 1 and 4 on 6-member ring of piperazine.

The organic amine functional groups in both (a) and (b) can be primary amine group, H₂N-, secondary organic amine group, HRN-, or tertiary organic amine group, RR'N-(also referred to as R"'₂N-). R, R', R" and R'" in (a) and (b) may be each independently selected from the groups listed as suitable for R₁ and R₂ above; R, R', R" and R'" can be the same or different. R" in (a) is preferably not an organic amine group.

The number of n can be varied from 1 to 6 which represent the different length of organic alkyl groups to bridge the nitrogen atom from piperazine ring and the nitrogen atom from organic amine or amino groups. n = 2 or 3 is preferred.

Also, the organic amine functional group at position 1 of piperazine can be the same as the organic amine functional group at position 4 of piperazine, or it can be different from the organic amine functional group at position 4 of piperazine.

In some preferred embodiments of formulae (a) and (b), R and R' are hydrogen. In this case, R" in formula (a) is preferably hydrogen and each R"' in formula (b) is preferably hydrogen. Suitably n = 2 or 3, so that preferred groups on the piperazine ring are 2-aminoethyl and 3-aminopropyl. Mono-substitution (formula (a)) or bis-substitution (formula (b)) are possible, with the substituents being the same or different.

Substitution or other modification (e.g. oxo groups) at carbons of the piperazine ring (2, 3, 5, 6 positions) is also contemplated.

Examples of such first type of chemical additives include, but are not limited to, 1-(Benzyloxycarbonyl)piperazine; (R)-piperazine-2-carboxylic acid; 1-(2-Hydroxyethyl)piperazine; Piperazine-2,6-dione; 1-(2-Aminoethyl)piperazine; 1,4-Bis(2-hydroxyethyl)piperazine; 1,4-Bis(acryloyl)piperazine; Piperazine-1-acetic acid *tert*-butyl ester; 1-(3-Methylbenzyl)piperazine; 4-Boc-piperazine-2-carboxylic acid; 1-(Diphenylmethyl)piperazine; 1,4-Di-Boc-piperazine-2-carboxylic acid; 2-(piperazine-1-carbonyl)-benzoic acid; 4-(Piperazine-1-carbonyl)-piperidine-1-carboxylic acid *tert*-butyl ester; piperazine-1-carboxylic acid; (2-chloro-phenyl)-amidepiperazine-1-carboxylic acid dimethylamide; piperazine-1-carboxylic acid diethylamide; piperazine-1-carboxylic acid diphenylamide; piperazine-1-sulfonamide; piperazine-2-carboxamide; 1,2-dimethyl-piperazine; 1-(2-butyl)-piperazine; 2-isobutyl-piperazine; 2-*tert*-butyl Piperazine; r-2-isobutyl-piperazine; s-2-isobutyl-piperazine; 2-isopropyl-piperazine; 1-(2-Pyrimidyl)piperazine; 1-(4-Trifluoromethylphenyl)piperazine; 1-(Cyclopropylmethyl)piperazine; 1-(2-pyrazinyl)-piperazine; 1-(2-trifluoromethylphenyl)-piperazine; 1-(6-Pyridazinyl)piperazine; 2-(4-trifluoromethylphenyl)piperazine; 2-phenylpiperazine-1-carboxylic acid benzyl ester; 1-(1-Naphthylmethyl)piperazine; 1-(1-pentyl)piperazine; 1-(2-pentyl)-piperazine; 1-(3-pentyl)-piperazine; 1-(propanoyl)-piperazine; 2-phenyl-piperazine-1-carboxylic acid *tert*-butyl ester; 1-Boc-piperazine; 1-(4-Chlorophenyl)piperazine; 1-(2-Furoyl)piperazine; 1-(2-Fluorophenyl)piperazine; 1-(2-Hydroxyphenyl)piperazine; 1-(2-Phenylethyl)piperazine; 1-(4-Fluorophenyl)piperazine; 1-(2-Methylbenzyl)piperazine; 1-(4-Hydroxyphenyl)piperazine; 1-(4-Methylbenzyl)piperazine; 1-(3-Hydroxyphenyl) piperazine; 1-(1-phenylethyl)piperazine; 1-(2,4-Dimethylphenyl)piperazine; 1-(2,5-Dimethylphenyl)piperazine; 1-(2,5-Dimethylphenyl)piperazine; 1-(2,6-xylyl)piperazine; 1-(2-ethylphenyl)piperazine; 1-(2-ethylphenyl)piperazine; 1-(3,4-dimethylphenyl)piperazine; 1-(3,5-Dimethylphenyl)piperazine; 1-(3-fluorophenyl)piperazine; 1-(3-furoyl)piperazine; 1-(N-heptyl)piperazine; 1-Pivaloyl-piperazine; 2,3-Dimethyl-piperazine-1-carboxylic acid *tert-*butyl ester; 2-(2-chlorophenyl)piperazine; 2-(4-chlorophenyl)piperazine; n-4-cbz-piperazine-2-carboxylate methyl ester; 1-(2-Pyridyl)piperazine; 1-(2-Methoxyphenyl)piperazine; 1-(4-Methoxyphenyl)piperazine; 1-(4-Chlorobenzhydryl)piperazine; 1-(4-Pyridyl)piperazine; 1-(4-Aminophenyl)piperazine; 1-(4-Methoxybenzyl)piperazine; 1-(2-Cyanophenyl)piperazine; 1-(1-Adamantyl)piperazine; 1-(4-Nitrophenyl)piperazine; 1-(2-Methoxyethyl)piperazine; 2-(Trifluoromethyl)piperazine; 1-(3,4-Dichlorophenyl)piperazine; 1-Boc-piperazine-2-carboxylic acid; 1-(2,5-Difluorobenzyl)piperazine; 1-(2-Ethoxyethyl)piperazine; 1-(3,4-Dichlorobenzyl)piperazine; 1-(3-Methoxyphenyl)piperazine; 1-(Cyclohexylmethyl)piperazine; 1-(3-Methylphenyl)piperazine; 1-(4-Methylphenyl)piperazine; 1-(3-Fluorobenzyl)piperazine; 1-(4-Fluorobenzyl)piperazine; 2-(3-Methoxyphenyl)piperazine; 1-(3-Chlorobenzyl)piperazine; 1-(Cyclopropylcarbonyl)piperazine; (*R*)-1-Boc-piperazine-2-carboxylic acid; (R)-2-benzyl-piperazine; (*R*)-3-Hydroxymethyl-piperazine-1-carboxylic acid *tert*-butyl ester; (R)-4-N-Boc-piperazine-2-carboxylic acid; S)-2-benzyl-piperazine; (*S*)-2-Benzyl-piperazine-1-carboxylic acid *tert-butyl* ester; (S)-3-Hydroxymethyl-piperazine-1-carboxylic acid *tert*-butyl ester; (*S*)-4-*N*-Boc-piperazine-2-carboxylic acid; 1-(1-Piperidinylsulfonyl)piperazine; 1-(2,2,2-trifluoroethyl)piperazine; 1-(2,3-Difluorophenyl)piperazine; 1-(2,4,6-Trimethylbenzyl)piperazine; 1-(2,4-Dichlorobenzyl)piperazine; 1-(2,4-Difluorophenyl)piperazine; 1-(2,6-Dichlorobenzyl)piperazine; 1-(2-Chlorobenzyl)piperazine; 1-(2-Cyclohexylethyl)piperazine; 1-(2-diisopropylaminoethyl)piperazine; 1-(2-Dipropylaminoethyl)-piperazine; 1-(2-Ethoxyphenyl)piperazine; 1-(2-ethylbutanoyl)piperazine; 1-(2-Fluorobenzyl)piperazine; 1-(2-Isopropoxyethyl)piperazine; 1-(2-methylmercaptophenyl)piperazine; 1-(2-methylpropanoyl)-piperazine; 1-(2-morpholinoethyl)piperazine; 1-(2-Phenoxyethyl)piperazine; 1-(2-piperidinoethyl)piperazine; 1-(2-pyrrolidinoethyl)piperazine; 1-(3,3-dimethylbutanoyl)piperazine; 1-(3,4-dichlorobenzoyl)piperazine; 1-(3-(3,5-dichlorophenyl)piperazine; 4-difluorobenzoyl)piperazine; 1-(3,4-dimethylbenzyl)piperazine; 1-(3,5-dimethoxybenzoyl)piperazine; 1-(3,5-dimethylbenzoyl)piperazine; 1-(3-aminopropyl)piperazine; 1-(3-cyanopropyl)piperazine; 1-(3-diethylaminopropyl)piperazine; 1-(3-dipropylaminopropyl)-piperazine; 1-(3-methoxypropyl)-piperazine; 1-(3-morpholinopropyl)piperazine; 1-(3-Phenylpropyl)piperazine; 1-(3-piperidinopropyl)piperazine; 1-(3-pyrrolidinopropyl)piperazine; 1-(4-chlorobenzoyl)piperazine; 1-(4-Chlorobenzyl)piperazine; 1-(4-ethoxyphenyl)piperazine; 1-(4-methoxybenzoyl)-piperazine; 1-(4-methoxybutyl)piperazine; 1-(4-phenylbutyl)-piperazine; 1-(4-pyridylmethyl)piperazine; 1-(4-*tert*-Butylbenzyl)piperazine; 1-(Cyclohexylcarbonyl)piperazine; 1-(Ethanesulfonyl)piperazine; 1-(phenylacetyl)piperazine; 1-cbz-piperazine-2-carboxylic acid; 1-hexanoyl-piperazine; 1-methylsulfonyl-piperazine; 2,3-diphenyl-piperazine; 2-(2-Furyl)piperazine; 2-(2-Methoxyphenyl)piperazine; 2-(2-Thienyl)piperazine; 2-(3-oxo-piperazine-1-carbonyl)-benzoic acid; 2-(4-Chlorophenyl)piperazine-1-carboxylic acid *tert*-butyl ester; 2-(4-Methoxyphenyl)piperazine; 2-(4-methylphenyl)piperazine; 2-benzyl-piperazine; 3-(4-Chlorophenyl)piperazine-1-carboxylic acid *tert*-butyl ester; 3-oxo-piperazine-2-carboxylic acid; 3-phenyl-piperazine-1-carboxylic acid ethyl ester; 4-(4-Boc-piperazine-1-carbonyl)phenylboronic acid pinacol ester; [5-(4-methyl-piperazine-1-sulfonyl)-pyridin-2-yl]-hydrazine; methyl piperazine-1-carboxylate; 1-ethyl-2-methyl-piperazine; 1,4-Bis(3-aminopropyl)piperazine; 1-[2-(2-Hydroxyethoxy)ethyl]piperazine; 1-(2-methyl-allyl)-piperazine; 2-(3-trifluoromethyl-phenyl)-piperazine; 4-*N*-Boc-2-methyl-piperazine; 1-(tetrahydro-2-furoyl)-piperazine; 1-(Tetrahydro-2-furylmethyl)piperazine; (*R*)-1-Boc-2-ethyl-piperazine; (*R*)-1-Boc-3-ethyl-piperazine; (*S*)-1-Boc-2-ethyl-piperazine; (*S*)-1-Boc-3-ethyl-piperazine; 1-[1-(2-methoxyphenyl)ethyl]piperazine; 1-[1-(3-methoxyphenyl)ethyl]piperazine; 1-[1-(4-methoxyphenyl)-ethyl]-piperazine; 1-[2-(2-Methylphenoxy)ethyl]piperazine; 1-(4-ethoxy-benzyl)-piperazine; 1-Boc-2,6-dimethyl-piperazine; 1-Boc-3,3-dimethyl-piperazine; 1-Boc-3,5-dimethyl-piperazine; 1-Boc-5-oxo-piperazine-2-carboxylic acid; 1-*N*-(*tert*-Butoxycarbonyl)-2-ethyl-piperazine; 2-(2-fluorophenyl)-piperazine; 2-(3-fluoro-phenyl)-piperazine; 2-methyl-1-(3-methylphenyl)piperazine; 4-(5-Aminopyridin-2-yl)piperazine-1-carboxylic acid *tert*-butyl ester; 1-[2-(Dimethylamino)ethyl]piperazine; 1-(1-Methyl-4-piperidinyl)piperazine; 1-Acetyl-4-(4-hydroxyphenyl)piperazine; 1-[4-(Trifluoromethyl)benzyl]piperazine; 1-Boc-4-(2-formylphenyl)piperazine; 1-Amino-4-(2-hydroxyethyl)piperazine; 1-Boc-(4-benzyl)piperazine; 1-Boc-4-[3-(ethoxycarbonyl)phenyl]piperazine; 1-Bis(4-fluorophenyl)methyl piperazine; 1-Boc-4-(3-hydroxypropyl)piperazine; 1-Boc-4-(4-formylphenyl)piperazine; 1-Boc-4-(4-methoxycarbonylphenyl)piperazine; 1-(1,3-Dioxolan-2-ylmethyl)piperazine; 1-(3-Aminopropyl)-4-(2-methoxyphenyl)piperazine; 1-[3-(Dimethylamino)propyl]piperazine; 1-(1,2,3,4-Tetrahydronaphthalen-2-yl)piperazine; 1-(4-Aminobutyl)-4-(2-methoxyphenyl)piperazine; 1-Boc-4-(2-methoxycarbonylphenyl)piperazine; 1-Boc-4-(5-nitro-2-pyridyl)piperazine; (*R*)-1-Boc-2-benzyl-piperazine; (*R*)-1-*N*-Boc-2-isopropyl piperazine; (*R*)-1-*N*-Boc-4-*N*-Fmoc-2-piperazine carboxylic acid; (R)-1-N-cbz-2-methyl-piperazine; (R)-4-N-trityl-2-methyl piperazine; (R)-N4-benzyl-2-(benzyloxymethyl)piperazine; (S)-1-Boc-2-hydroxymethyl-piperazine; (S)-1-Boc-2-isobutyl-piperazine; (*S*)-1-Boc-3-benzyl-piperazine; (*S*)-1-Boc-3-isopropyl-piperazine; (*S*)-1-*N*-Boc-4-*N*-Fmoc-piperazine-2-carboxylic acid; (S)-4-N-trityl-2-methyl-piperazine; (S)-n4-benzyl-2-(methylthioethyl)piperazine; 1-[(2,6-dichlorophenyl)sulfonyl]piperazine; 1-[(2-Methyl-1,3-thiazol-5-yl)methyl]piperazine; 1-[(4,5-Dimethyl-1,3-oxazol-2-yl)methyl]piperazine; 1-[(4-cyclohexylphenyl)sulfonyl]piperazine; 1-[(4-Isobutylphenyl)sulfonyl]piperazine; 1-[(4-Methyl-1,2,5-oxadiazol-3-yl)methyl]piperazine; 1-[(4-*sec*-Butylphenyl)sulfonyl]piperazine; 1-[(4-*tert*-Butyl-2,6-dimethylphenyl)sulfonyl]piperazine; 1-[1-(pyridin-2-yl)ethyl]piperazine; 1-[1-(pyridin-3-yl)ethyl]piperazine; 1-[1-(thiophen-2-yl)ethyl]piperazine; 1-[2-(1-propyl)-oxyethyl]-piperazine; 1-[2-(1*H*-Pyrrol-1-yl)ethyl]piperazine; 1-[2-(2-methoxy-phenoxy)-ethyl]-piperazine; 1-[2-(diallylamino)-ethyl]-piperazine; 1-[2-(trifluoromethyl)pyridin-4-yl]piperazine; 1-[2-(trifluoromethyl)quinol-4-yl]piperazine; 1-[2-Fluoro-4-(methylsulfonyl)phenyl]piperazine; 1-[2-Fluoro-4-(methylsulphonyl)phenyl]-4-(2-hydroxyethyl)piperazine; 1-[3-(1-Piperidinylcarbonyl)-2-pyridinyl]piperazine; 1-[3-(difluoromethoxy)benzoyl]piperazine; 1-[3-(trifluoromethyl)pyrid-2-yl]piperazine; 1-[4-(methylsulfonyl)phenyl]piperazine; 1-[4-(trifluoromethyl)pyrimid-2-yl]piperazine; 1-(1H-Imidazol-2-ylmethyl)piperazine; 1-(2,6-Dimethylpyridin-4-yl)piperazine; 1-(2-benzhydryloxy-ethyl)-piperazine; 1-(2-hydroxyethyl)-4-isopropyl-piperazine; 1-(2-imidazol-1-yl-ethyl)-piperazine; 1-(2-isocyano-ethyl)-4-methyl-piperazine; 1-(2-Methyl-thiazol-4-ylmethyl)-piperazine; 1-(2-*N*-Boc-aminoethyl)piperazine; 1-(2-pyridin-2-yl-ethyl)-piperazine; 1-(2-pyridin-4-yl-ethyl)-piperazine; 1-(2-thiophen-2-yl-ethyl)piperazine; 1-(3,5-dimethyl-isoxazol-4-ylmethyl)-piperazine; 1-(3-methoxy-benzyl)-piperazine; 1-(3-methylbenzoyl)-piperazine; 1-(3-methyl-pyridin-2-ylmethyl)-piperazine; 1-(3-Methylpyridin-2-yl)piperazine; 1-(3-methylpyridin-4-yl)piperazine; 1-(4,6-dimethylpyrimidin-2-yl)piperazine; 1-(4-cyano-benzyl)-piperazine; 1-(4-ethoxy-benzenesulfonyl)-piperazine; 1-(4-Ethoxy-pyridin-2-yl)-piperazine; 1-(4-Fluorobenzyl)-4-(2-hydroxyethyl)piperazine; 1-(4-Hydroxy-phenyl)-piperazine-4-carboxylic acid *tert*-butyl ester; *N*-Boc-piperidine; 2-Methylpiperazine; 2,6-Dimethylpiperazine; *trans*-2,5-Dimethylpiperazine; 1,4-Dimethylpiperazine; (*R*)-1-Boc-3-methylpiperazine; 1-Boc-3-oxopiperazine; 1,4-BIS-(2-METHOXY-5-METHYL-BENZENESULFONYL)-2-METHYL-PIPERAZINE; 1-[(1-METHYL-1H-PYRAZOL-3-YL)CARBONYL]PIPERAZINE; 1-[(1-METHYL-1 H-PYRAZOL-4-YL)METHYL]PIPERAZINE; 1-(2-(N,N-BIS-(2-HYDROXYPROPYL)-AMINO)-ETHYL)-4-(2-HYDROXYPROPYL)-PIPERAZINE; 1-(2-METHOXYPHENYL)-4-((4-(2-METHOXYPHENYL)-1-PIPERAZINYL)(OXO)ACETYL)PIPERAZINE; 1-(3-(2,3-DIHYDRO-1,4-BENZODIOXIN-6-YL)ACRYLOYL)-4-(4-FLUOROPHENYL)PIPERAZINE; 1-(4-CHLOROPHENYL)-4-[(7-{[4-(4-CHLOROPHENYL)-1-PIPERAZINYL]SULFONYL}-9H-FLUOREN-2-YL)SULFONYL]PIPERAZINE; 1-(4-FLUOROPHENYL)-4-((4-(4-FLUOROPHENYL)-1-PIPERAZINYL)(OXO)ACETYL)PIPERAZINE; 1-(4-NITROPHENYL)-4-(3-{[4-(4-NITROPHENYL)-1-PIPERAZINYL]CARBONYL}BENZOYL)PIPERAZINE; 1-(4-NITROPHENYL)-4-(4-{[4-(4-NITROPHENYL)-1-PIPERAZINYL]CARBONYL}BENZOYL)PIPERAZINE; 1-ACETYL-4-(1-ETHYL-1H-IMIDAZOL-2-YL)PIPERAZINE; 1-BENZHYDRYL-4-{2-[5-(BENZYLSULFANYL)-4-(2-METHYL-2-PROPENYL)-4H-1,2,4-TRIAZOL-3-YL]ETHYL}PIPERAZINE; 1-BENZYL-4-[2-[(2',4'-DIFLUORO[1,1'-BIPHENYL]-4-YL)OXY]ETHYL]PIPERAZINE; 1-BENZYL-4-(3-((2',4'-DIFLUORO(1,1'-BIPHENYL)-4-YL)OXY)PROPYL)PIPERAZINE; 1-ISOPROPYL-4-[(1-METHYL-1 H-PYRROL-2-YL)METHYL]PIPERAZINE; 1-METHYL-4-({7-[(4-METHYL-1-PIPERAZINYL)SULFONYL]-9H-FLUOREN-2-YL}SULFONYL)PIPERAZINE; 1-phenyl-4-[phenyl(4-phenyl-1-piperazinyl)methyl]piperazine; 1-methyl-4-(methylsulfonyl)piperazine; 4-(2-HYDROXY-ETHYL)-PIPERAZINE-1-CARBOXYLIC ACID (4-ISOPROPYLPHENYL)-AMIDE; 6-HYDROXYMETHYL-1,3-DIMETHYL-PIPERAZINE-2,5-DIONE; BIS(2-METHOXYPHENYL) 2,2'-(PIPERAZINE-1,4-DIYL)DIETHANESULFONATE; 1-(ADAMANTANE-1-SULFINYL)-4-METHYL-PIPERAZINE; 1-(PHENYLSULFONYL)-4-(2-PYRIDINYL)PIPERAZINE; 1-BENZYL-4-(2-METHOXYPROPANOYL)PIPERAZINE; 1-CYCLOHEXYL-4-(METHYLSULFONYL)PIPERAZINE; 1-ETHYL-4-(3-FURYLMETHYL)PIPERAZINE; 1-(3-phenoxy-4-pyridinyl)piperazine; 1-(2-PYRIDINYL)-4-(3-(2,3,4-TRIMETHOXYPHENYL)ACRYLOYL)PIPERAZINE; 1-(3-(1,3-BENZODIOXOL-5-YL)ACRYLOYL)-4-(2-PYRIDINYL)PIPERAZINE; 1-(3-(1,3-BENZODIOXOL-5-YL)ACRYLOYL)-4-(4-METHOXYPHENYL)PIPERAZINE; 1,4-BIS-(2-PYRIDYLMETHYLENEAMINO)-PIPERAZINE; 1,4-BIS-(3,4,5-TRIMETHOXYBENZYLIDENEAMINO-PIPERAZINE; 1,4-BIS-(ACETOACETYL)-PIPERAZINE; 1,4-di(2-furoyl)piperazine; 1,4-bis[2-(4-pyridinyl)ethyl]piperazine; 1,4-BIS(2-(2-PYRIDINYL)ETHYL)PIPERAZINE; 1,4-BIS(2-CARBOXYBENZOYL)PIPERAZINE; 1,4-bis(3-pyridinylmethyl)piperazine; 1-(ETHOXYCARBONYLMETHYL)PIPERAZINE; 2,3,5,6-TETRAHYDROXY-PIPERAZINE-1,4-DICARBALDEHYDE; 4-BENZYL-PIPERAZINE-1-CARBOXYLIC ACID CYCLOHEXYLAMIDE; diethyl 2,2'-(piperazine-1,4-diyl)bis(2-oxoacetate); diethyl 2,2'-(piperazine-1,4-diyl)diacetate; dimethyl 3,3'-(piperazine-1,4-diyl)dipropanoate; (2E,2'E)-3,3'-(piperazine-1,4-diyl)bis(1-(2-hydroxyphenyl)prop-2-en-1-one); 2,2'-(PIPERAZINE-1,4-DIYL)BIS(N-(1,5-DIMETHYL-3-OXO-2-PHENYL-2,3-DIHYDRO-1 H-PYRAZOL-4-YL)ACETAMIDE); 2,2'-(piperazine-1,4-diyl)dipropanamide; 2,2'-(piperazine-1,4-diyl)dipropanenitrile; 3,3'-(PIPERAZINE-1,4-DIYL)BIS(1-(9H-CARBAZOL-9-YL)PROPAN-2-OL) FUMARATE; 3,3'-(piperazine-1,4-diyl)bis(1-phenylpropan-1-one); 3,3'-(piperazine-1,4-diyl)dipropan-1-ol; 4,4'-(piperazine-1,4-diyl)bis(3-ethoxycyclobut-3-ene-1,2-dione; PIPERAZINE-1,4-DICARBOTHIOIC ACID BIS-PHENYLAMIDE; 1,4-DI-TERT-BUTYL-PIPERAZINE-2,5-DIONE; 1,4-DIDODECYL-PIPERAZINE; 1,4-DIHEXADECYL-PIPERAZINE; 1-(1-PIPERIDINYLCARBONYL)PIPERAZINE; 1-(1-ADAMANTYLMETHYL)PIPERAZINE; 1-(3,4-dimethoxybenzyl)piperazine; 1-(3-PYRIDINYLCARBONYL)PIPERAZINE; 4-Piperazinobenzonitrile; (S)-3-Methyl-2-ketopiperazine; (R)-3-Methyl-2-ketopiperazine; 4-(Boc-piperazin-1-yl)-3-nitrobenzoic acid; 1,1'-(piperazine-1,4-diyl)dipropan-2-ol; 2,2'-(piperazine-1,4-diyl)bis(1-phenylethanol); 2,2'-(piperazine-1,4-diyl)bis(2-methylpropanenitrile); Piperazine-N,N'-bis(2-ethanesulfonic acid); 1-Formylpiperazine; PIPES sodium salt; PIPES disodium salt; PIPES dipotassium salt; Piperazine-N,N'-bis(2-hydroxypropanesulfonic acid); Ethyl 1-piperazinecarboxylate; POPSO disodium salt; 4-Hydroxy-3-methoxyphenylglycol hemipiperazinium salt; Citric acid sesquipiperazine salt hydrate; 4-(2-Hydroxyethyl)piperazine-1-ethanesulfonic acid; 4-(2-Hydroxyethyl)-1-piperazinepropanesulfonic acid; HEPES sodium salt; N-(2-Hydroxyethyl)piperazine-N'-(4-butanesulfonic acid); 3-Methyl-2-ketopiperazine; HEPES potassium salt; 3-Piperazinopropionitrile; Ethyl piperazinoacetate; Estropipate; 1-Piperazinepropanol; t-butyl-4-(2-Amino-1-phenylethyl)piperazine carboxylate; *tert-*Butyl 4-[2-(aminomethyl)phenyl]piperazine-1-carboxylate; *tert-*Butyl 4-[5-(hydroxymethyl)pyrid-2-yl]piperazine-1-carboxylate; *tert-*Butyl 4-(3-aminobenzyl)piperazine-1-carboxylate; *tert-*Butyl 4-(4-[(methylamino)methyl]phenyl)piperazine-1-carboxylate; *tert-*Butyl 4-(4-cyanopyrid-2-yl)piperazine-1-carboxylate; *tert-*Butyl 4-(5-formylpyrid-2-yl)piperazine-1-carboxylate; tert-Butyl 4-(oxetan-3-yl)piperazine-1-carboxylate; *tert-*Butyl 4-(piperidin-3-yl)piperazine-1-carboxylate; *tert-*Butyl 4-(pyrrolidin-2-ylcarbonyl)piperazine-1-carboxylate; *tert-*Butyl 4-(1H-pyrrolo[2,3-b]pyridin-4-yl)piperazine-1-carboxylate; 1-[2-(2,5-dimethyl-1 H-pyrrol-1-yl)ethyl]piperazine; 1-((1,5-dimethyl-1 H-pyrazol-4-yl)methyl)piperazine; 1-(1-Ethyl-5-methyl-1*H*-pyrazol-4-ylmethyl)-piperazine; t-butyl4-(2-Amino-1-[4-(trifluoromethyl)phenyl]ethyl)piperazine carboxylate; 3-(4-Fluoro-phenyl)-piperazine-1-carboxylic acid *tert*-butyl ester; 3-(4-Hydroxy-phenyl)-piperazine-1-carboxylic acid *tert-*butyl ester; 3-Furan-2-yl-piperazine-1-carboxylic acid *tert*-butyl ester; 3-thiophen-2-yl-piperazine-1-carboxylic acid benzyl ester; 4-(2-Amino-phenyl)-piperazine-1-carboxylic acid *tert*-butyl ester; 4-(2-Aminoethyl)-1-boc-piperazine; 4-(5-Carboxy-pyridin-2-yl)-2-methyl-piperazine-1-carboxylic acid *tert*-butyl ester; 4-Boc-1-(6-methyl-2-pyridyl)piperazine; Fmoc-4-carboxymethyl-piperazine; Methyl 4-Boc-piperazine-2-carboxylate; N,N-dimethyl-1-piperazine sulfonamide; *N*-1-Boc-*N*-4-Fmoc-2-Piperazine carboxylic acid; *N*-4-Boc-*N*-1-cbz-2-piperazine carboxylic acid; *N*-4-Boc-*N*-1-Fmoc-2-Piperazine acetic acid; sulfuric acid compound with piperazine-1-carboximidamide (1:1); 1-ethyl-4-piperidin-4-yl-piperazine; 1-furan-2-ylmethyl-piperazine; 1-methyl-4-(2-piperidin-4-yl-ethyl)-piperazine; 1-Methyl-4-(6-aminopyridin-3-yl)piperazine; 1-methyl-4-(piperidin-4-yl)-piperazine; 1-*N*-Boc-4-(azetidin-3-yl)piperazine; 1-pyridin-2-ylmethyl-piperazine; 1-Pyridin-3-ylmethyl-piperazine; 1-thiazol-2-yl-piperazine; 2-(2,5-dimethoxy-phenyl)-piperazine; 2-Carboxymethyl-3-oxo-piperazine-1-carboxylic acid *tert*-butyl ester; 2-Ethoxycarbonylmethyl-3-oxo-piperazine-1-carboxylic acid *tert-butyl* ester; 1-(4-methylcyclohexyl)-piperazine; 1-(4-methyl-piperidine-1-sulfonyl)-piperazine; 1-(4-trifluoromethyl-pyridin-2-yl)-piperazine; 1-(5-Methyl-2-pyridinyl)piperazine; 1-(5-Methyl-2-thiazolyl)-piperazine; 1-(5-Nitropyridin-2-yl)piperazine; 1-(6-Butoxy-2-pyridinyl)piperazine; 1-(6-methylpyrid-2-yl)piperazine; 1-(N-Methylpiperidin-3-yl-methyl)piperazine; 1-(thien-2-ylacetyl)piperazine; 1-Boc-4-(piperidin-4-yl)-piperazine; 1-Boc-4-cyanomethyl piperazine; 1-cyclohex-3-enylmethyl-piperazine.

The piperazine derivative preferably is selected from the group consisting of (R)-piperazine-2-carboxylic acid; 1-(2-Hydroxyethyl)piperazine; Piperazine-2,6-dione; 1-(2-Aminoethyl)piperazine; 1,4-Bis(2-hydroxyethyl)piperazine; 1,4-Bis(acryloyl)piperazine; Piperazine-1-acetic acid *tert*-butyl ester; 1-(3-Methylbenzyl)piperazine; 4-(Piperazine-1-carbonyl)-piperidine-1-carboxylic acid *tert*-butyl ester; piperazine-1-carboxylic acid diethylamide; piperazine-1-sulfonamide; piperazine-2-carboxamide; 1,2-dimethyl-piperazine; 2-isopropyl-piperazine; 1-(2-Pyrimidyl)piperazine; 1-(2-pyrazinyl)-piperazine; 1-(6-Pyridazinyl)piperazine; 1-(3-Hydroxyphenyl) piperazine; 1-(2-Pyridyl)piperazine; 1-(4-Methoxyphenyl)piperazine; 1-(4-Pyridyl)piperazine; 1-(4-Aminophenyl)piperazine; 1-(4-Methoxybenzyl)piperazine; 1-(2-Cyanophenyl)piperazine; 1-(2-Methoxyethyl)piperazine; 1-Boc-piperazine-2-carboxylic acid; 1-(2-Ethoxyethyl)piperazine; (*R*)-1-Boc-piperazine-2-carboxylic acid; (*R*)-3-Hydroxymethyl-piperazine-1-carboxylic acid *tert*-butyl ester; (R)-4-N-Boc-piperazine-2-carboxylic acid; (S)-3-Hydroxymethyl-piperazine-1-carboxylic acid *tert-butyl* ester; (*S*)-4-*N*-Boc-piperazine-2-carboxylic acid; 1-(1-Piperidinylsulfonyl)piperazine; 1-(2-diisopropylaminoethyl)piperazine; 1-(2-Dipropylaminoethyl)-piperazine; 1-(2-Ethoxyphenyl)piperazine; 1-(2-ethylbutanoyl)piperazine; 1-(2-Isopropoxyethyl)piperazine; 1-(2-methylmercaptophenyl)piperazine; 1-(2-morpholinoethyl)piperazine; 1-(2-piperidinoethyl)piperazine; 1-(2-pyrrolidinoethyl)piperazine; 1-(3-aminopropyl)piperazine; 1-(3-cyanopropyl)piperazine; 1-(3-diethylaminopropyl)piperazine; 1-(3-dipropylaminopropyl)-piperazine; 1-(3-methoxypropyl)-piperazine; 1-(3-morpholinopropyl)piperazine; 1-(3-piperidinopropyl)piperazine; 1-(3-pyrrolidinopropyl)piperazine; 1-(4-methoxybutyl)piperazine; 1-(4-pyridylmethyl)piperazine; 1-(Ethanesulfonyl)piperazine; 3-oxo-piperazine-2-carboxylic acid; 4-methyl piperazine-1-carboxylate; 1,4-Bis(3-aminopropyl)piperazine; 1-[2-(2-Hydroxyethoxy)ethyl]piperazine; 4-(5-Aminopyridin-2-yl)piperazine-1-carboxylic acid *tert-*butyl ester; 1-[2-(Dimethylamino)ethyl]piperazine; 1-(1-Methyl-4-piperidinyl)piperazine; 1-Amino-4-(2-hydroxyethyl)piperazine; 1-(3-Aminopropyl)-4-(2-methoxyphenyl)piperazine; 1-[3-(Dimethylamino)propyl]piperazine; 1-(4-Aminobutyl)-4-(2-methoxyphenyl)piperazine; 1-[3-(1-Piperidinylcarbonyl)-2-pyridinyl]piperazine; 1-(1H-Imidazol-2-ylmethyl)piperazine; 1-(2,6-Dimethylpyridin-4-yl)piperazine; 1-(2-hydroxyethyl)-4-isopropyl-piperazine; 1-(2-imidazol-1-yl-ethyl)-piperazine; 1-(2-isocyano-ethyl)-4-methyl-piperazine; 1-(4-Ethoxy-pyridin-2-yl)-piperazine; 2-Methylpiperazine; 2,6-Dimethylpiperazine; *trans-2,5-*Dimethylpiperazine; 1,4-Dimethylpiperazine; 1,4-bis(3-pyridinylmethyl)piperazine; 1-(ETHOXYCARBONYLMETHYL)PIPERAZINE; 2,3,5,6-TETRAHYDROXY-PIPERAZINE-1,4-DICARBALDEHYDE; dimethyl 3,3'-(piperazine-1,4-diyl)dipropanoate; 2,2'-(piperazine-1,4-diyl)dipropanamide; 2,2'-(piperazine-1,4-diyl)dipropanenitrile; (R)-3-Methyl-2-ketopiperazine; 2,2'-(piperazine-1,4-diyl)bis(2-methylpropanenitrile); Piperazine-N,N'-bis(2-ethanesulfonic acid); 1-Formylpiperazine; PIPES sodium salt; PIPES disodium salt; PIPES dipotassium salt; Piperazine-N,N'-bis(2-hydroxypropanesulfonic acid); Ethyl 1-piperazinecarboxylate; POPSO disodium salt; 4-Hydroxy-3-methoxyphenylglycol hemipiperazinium salt; 4-(2-Hydroxyethyl)piperazine-1-ethanesulfonic acid; 4-(2-Hydroxyethyl)-1-piperazinepropanesulfonic acid; HEPES sodium salt; N-(2-Hydroxyethyl)piperazine-N'-(4-butanesulfonic acid); 3-Methyl-2-ketopiperazine; HEPES potassium salt; 3-Piperazinopropionitrile; Ethyl piperazinoacetate; and combinations thereof.

Where an *(R)* or *(S)* enantiomer of an optically active compound is specified, the opposite enantiomer, and a racemic or other mixture of the enantiomers is also contemplated. The same applies for other stereoisomers e.g. E/Z or *cis*/*trans* diastereomers.

Two examples of such first type of chemical additives as corrosion inhibitors for the disclosed tungsten CMP polishing compositions are: mono-substituted 1-(2-aminoethyl) piperazine (for (a)) and bis-substituted 1, 4-Bis (3-aminopropyl) piperazine (for (b)).

The CMP slurry of this invention preferably contains the first type of chemical additives ranging from 0.0001 % to 0.10%; preferably ranging from 0.0005% to 0.010%.

The second type of chemical additives with dual functions to provide corrosion protection on tungsten metal film surface as corrosion inhibitors and boost tungsten film removal rates as tungsten removal rate boosters include: various salts of cyanate (CNO). These cyanate salts include potassium cyanate, sodium cyanate, ammonium cyanate, and alkylammonium cyanates including tetraalkylammonium cyanate.

The CMP slurry of this invention preferably contains the second type of chemical additives ranging from 0.0002% to 0.5%; preferably ranging from 0.001% to 0.25%.

Oxidizers used for the disclosed tungsten CMP slurries include, but are not limited to, the following: periodic acid, hydrogen peroxide, potassium iodate, potassium permanganate, ammonium persulfate, ammonium molybdate, ferric nitrate, nitric acid, potassium nitrate, and mixtures thereof. The preferred oxidizer is hydrogen peroxide.

The CMP slurry of this invention contains 0.5 wt% to 10 wt% of an oxidizer; preferably from 1 wt% to 4 wt%, and most preferably from 2 wt% to 3 wt%.

The liquid carrier which typically provides the principal portion of the liquid component can be water or mixtures of water with other liquids that are miscible with water. Advantageously the solvent is water, such as DI (deionized) water.

pH buffering agents used for the disclosed tungsten CMP slurries include, but are not limited to, the following: nitric acid, hydrochloric acid, sulfuric acid, phosphoric acid, other inorganic or organic acids, and mixtures thereof. The preferred pH adjusting agent is nitric acid.

The CMP slurry of this invention suitably contains 0.01 wt% to 0.5 wt% nitric acid; preferably from 0.05 wt% to 0.15 wt%.

The corrosion inhibitors used for the disclosed tungsten CMP slurries include, but are not limited to: polyethylenimine, and other organic polymeric or oligomeric primary and secondary amines.

The CMP slurry of this invention optionally contains corrosion inhibitors preferably ranging from 0.0001 wt% to 0.25 wt%; preferably ranging from 0.0003 wt% to 0.01 wt%.

The surfactants used for the disclosed tungsten CMP slurries include, but are not limited to, the following

### (a). Non-ionic surface wetting agents

These agents typically are oxygen- or nitrogen-containing compounds with various hydrophobic and hydrophilic moieties in the same molecules. The molecular weight ranges from several hundreds to over 1 million. The viscosities of these materials also possess a very broad distribution.

### (b). Anionic surface wetting agents

These compounds possess a negative net charge on the major part of the molecular frame, these compound include, but are not limited to, the following salts with suitable hydrophobic tails: alkyl carboxylate, alkyl sulfate, alkyl phosphate, alkyl bicarboxylate, alkyl bisulfate, alkyl biphosphate, alkoxy carboxylate, alkoxy sulfate, alkoxy phosphate, alkoxy bicarboxylate, alkoxy bisulfate, alkoxy biphosphate, substituted aryl carboxylate, substituted aryl sulfate, substituted aryl phosphate, substituted aryl bicarboxylate, substituted aryl bisulfate, substituted aryl biphosphate etc. The counter ions for this type of surface wetting agents include, but are not limited to, the following ions: potassium, ammonium and other positive ions. The molecular weights of these anionic surface wetting agents range from several hundred to several hundred-thousands.

### (c). Cationic surface wetting agents

These compounds possess a positive net charge on the major part of the molecular frame, these compounds include, but are not limited to, the following salts with suitable hydrophilic tails: carboxylate, sulfate, phosphate, bicarboxylate, bisulfate, biphosphate, etc. The counter ions for this type of surface wetting agents include, but are not limited to, the following ions: potassium, ammonium and other positive ions. The molecular weights of these anionic surface wetting agents range from several hundred to several hundred-thousands.

### (d). Ampholytic surface wetting agents

These compounds possess both positive and negative charges on the main molecular chains and with their relative counter ions. The examples of such bipolar surface wetting agents include, but are not limited to, the salts of amino-carboxylic acids, amino-phosphoric acid, and amino-sulfonic acid.

The surfactants optionally used in the tungsten CMP slurries preferably range from 0.0001% to 0.50%; preferably ranging from 0.0005% to 0.10%.

The biocides used for the disclosed tungsten CMP slurries include, but are not limited to, commercial available biocide products, such as Kathon, Kathon II and others.

The biocides optionally used in the tungsten CMP slurries preferably range from 0.0001% to 0.1%; preferably ranging from 0.0005% to 0.010%.

The present invention is further demonstrated by the examples below.

### Working Example

The associated processes described herein entail use of the aforementioned composition for chemical mechanical planarization of substrates comprised of tungsten.

In the processes, a substrate (e.g., a wafer with W surface) is placed face-down on a polishing pad which is fixedly attached to a rotatable platen of a CMP polisher. In this manner, the substrate to be polished and planarized is placed in direct contact with the polishing pad. A wafer carrier system or polishing head is used to hold the substrate in place and to apply a downward pressure against the backside of the substrate during CMP processing while the platen and the substrate are rotated. The polishing composition (slurry) is applied (usually continuously) on the pad during CMP processing to effect the removal of material to planarize the substrate.

The polishing composition and associated processes described herein are effective for CMP of a wide variety of substrates, and are particularly useful for polishing tungsten substrates.

### General Experimental Procedure

In the examples presented below, CMP experiments were run using the procedures and experimental conditions given below.

The CMP tool that was used in the examples is a Mirra^{®}, manufactured by Applied Materials, 3050 Boweres Avenue, Santa Clara, California, 95054. An IC-1010 pad, supplied by Dow Chemicals, was used on the platen for the blanket wafer polishing studies. Pads were broken-in by polishing twenty-five dummy oxide (deposited by plasma enhanced CVD from a TEOS precursor, PETEOS) wafers.

In order to qualify the tool settings and the pad break-in, two PETEOS monitors were polished with Syton^{®} OX-K colloidal silica, supplied by Planarization Platform of Air Products Chemicals Inc. at baseline conditions. Polishing experiments were conducted using blanket W wafer with 8K Angstroms in thickness, and TEOS wafer. These blanket wafers were purchased from Silicon Valley Microelectronics, 1150 Campbell Ave, CA, 95126.

### Parameters

Å: angstrom(s) - a unit of length
W: tungsten
BP: back pressure, in psi units
CMP: chemical mechanical planarization = chemical mechanical polishing
CS: carrier speed
DF: Down force: pressure applied during CMP, unit psi
min: minute(s)
ml: milliliter(s)
mV: millivolt(s)
psi: pounds per square inch
PS: platen rotational speed of polishing tool, in rpm (revolution(s) per minute)
SF: polishing composition flow, ml/min
wt%: weight percentage (of a listed component)
TEOS: tetraethylorthosilicate
NU% (or WIWNU%): With-In Wafer Non-Uniformity%
NU% = (|W film thickness pre-polishing - W film thickness post-polishing| /mean of total W film thickness) X 100%
W RR 3.0 psi: Measured tungsten removal rate at 3.0 psi (21 kPa) down pressure of the CMP tool
TEOS RR 3.0 psi: Measured TEOS removal rate at 3.0 psi (21 kPa) down pressure of the CMP tool
W:TEOS Selectivity: (removal rate of W)/(removal rate of TEOS) at same down force (3.0 psi, 21 kPa)

### Static etch rate

Static etch rate is a measurement that provides empirical data related to the chemical activity level of a CMP slurry. Typically, a higher static etch rate is indicative of a more aggressive chemical composition that leads to the relative fast etching of the related metal film surfaces, with a higher probability of causing more metal corrosion defects.

Chips cut from a tungsten blanket wafer were exposed to both the standard tungsten slurry and the disclosed CMP tungsten polishing formulations.

The Standard W Slurry shown in Table 1 comprises:
0.4 wt% solid catalyst - ferric oxide coated on colloidal silica;
0.5 wt% colloidal silica;
3.0 wt% hydrogen peroxide; and
balance is DI Water;
pH at the point of use is around 3.4.

Table 1 showed the normalized data of the static etch rate collected at temperature 40°C for 5 minutes.

The addition of the selected chemical additives into the standard W slurry acted as corrosion inhibitors at temperature 40°C, lowered the static etch rate by 90% for 1(2-aminoethyl)piperazine as additive, by 84% for potassium cyanate as additive, and by 74% for 1,4-diazabicyclo[2.2.2]octane (comparative) as additive, respectively.

0.00025% for 1(2-aminoethyl)piperazine, 0.001% for potassium cyanate, and 0.010% for 1,4-diazabicyclo[2.2.2]octane, were added to the standard W slurry for the tests shown in Table 1, respectively.

The data in Table 1 suggests superior corrosion protection at the temperature (40°C) reached due to friction during polishing.

**Table 1. Effect of corrosion inhibitor on static etch rate of tungsten metal**

| Samples | Static etch rate (Å/min) at 40°C, normalized |
|---|---|
| Standard W Slurry (comparative) | 1.00 |
| Standard W Slurry + 1(2-aminoethyl)piperazine | 0.097 |
| Standard W Slurry + potassium cyanate | 0.156 |
| Standard W Slurry + 1,4-diazabicyclo[2.2.2]octane (comparative) | 0.256 |

### Chemical mechanical polishing

Chemical mechanical polishing was conducted using the first type of chemical additives as corrosion inhibitors and second type of chemical additives as dual functional additives to provide corrosion protection on tungsten metal film surfaces and boost tungsten film removal rates.

The testing results were listed in Table 2 and 3 for the first and the second chemical additives, respectively.

In Table 2, 10 ppm (0.001 wt%) of 1-(2-aminoethyl)piperazine was defined as 1X of 1-(2-aminoethyl)piperazine added into the standard W slurry formulation.

Standard W Slurry shown in Table 2 comprises:
0.4 wt% solid catalyst - ferric oxide coated on colloidal silica;
0.5 wt% colloidal silica;
3.0 wt% hydrogen peroxide; and
balance is DI Water;
pH at the point of use is around 3.4.

**Table 2. Effects of First Type of Chemical Additive on W CMP Slurry Performance**

| Sample | W RR (Å/min) | NU% | TEOS RR | W:TEOS Selectivity | W RR% Change |
|---|---|---|---|---|---|
| Standard W Slurry (comparative) | 3908 | 10.07 | 36 | 109 | |
| 1-(2-aminoethyl)piperazine 0.3X | 3593 | 8.86 | 42 | 86 | 8.8%(-) |
| 1-(2-aminoethyl)piperazine 1X | 2862 | 4.76 | 64 | 45 | 36.5%(-) |
| 1-(2-aminoethyl)piperazine 2.5X | 2314 | 4.25 | 81 | 29 | 68.9%(-) |
| 1-(2-aminoethyl)piperazine 5X | 2022 | 4.40 | 114 | 18 | 93%(-) |

As the results shown in Table 2, adding the first type of chemical additive, specifically, 1-(2-aminoethyl) piperazine into the standard W CMP slurry, NU% was reduced.

Because 1-(2-aminoethyl) piperazine behaved as the strong corrosion inhibitor for W CMP slurry formulations, tungsten removal rates were decreased as the concentration of 1-(2-aminoethyl) piperazine was increased.

Table 2 also indicated the tunable Selectivity of W:TEOS as the concentration of 1-(2-aminoethyl) piperazine was changed.

In Table 3, 25 ppm (0.0025 wt%) of potassium cyanate was defined as 1X potassium cyanate used in the sample slurries.

1X KCNO slurry In Table 3 comprising:
0.4 wt% solid catalyst - ferric oxide coated on colloidal silica;
0.5 wt% colloidal silica;
3.0 wt% hydrogen peroxide;
25 ppm of potassium cyanate; and
balance is DI Water;
pH at the point of use is around 3.4.

The Reference W Slurry shown in Table 3 comprises:
0.4 wt% solid catalyst- ferric oxide coated on colloidal silica;
0.5 wt% colloidal silica;
3.0 wt% hydrogen peroxide;
0.00037 wt% polyethylenimine; and
balance is DI Water;
pH at the point of use is around 3.4.

**Table 3. Effects of Second Type of Chemical Additive on W CMP Slurry Performance**

| Sample | W RR (Å/min) | NU% | TEOS RR | W:TEOS Selectivity | W RR% Change |
|---|---|---|---|---|---|
| Reference W Slurry (comparative) | 4787 | 6.29 | 34 | 141 | |
| 1X KCNO/standard W Slurry | 6044 | 3.07 | 18 | 336 | 26.3%(+) |
| 2X KCNO/standard W Slurry | 5982 | 2.93 | 18 | 332 | 25.0%(+) |
| 4X KCNO/standard W Slurry | 5979 | 2.87 | 22 | 272 | 25.0%(+) |

As the results show in Table 3, adding the second type of chemical additive, potassium cyanate, into the standard tungsten CMP slurry, several outstanding results were observed.

The tungsten film removal rates increased by more than 25% when 1X, 2X, or 4X concentration of potassium cyanate was added into the standard tungsten chemical mechanical polishing composition.

The NU% was reduced from 6.29% to 3.07%, 2.93% and 2.87% when 1X, 2X and 4X of potassium cyanate were used as additives, respectively.

The selectivity in polishing W/D films was increased from 141 to 336, 332, and 272 when 1X, 2X, and 4X of potassium cyanate used as additives, respectively.

The use of potassium cyanate provided high selectivity as well as tunable selectivity of W:TEOS while reduced the NU %.

Even at 2 ppm concentration of potassium cyanate (0.08X POU concentration), more than 20 % W film removal rate increasing with NU % at 4.02% was still observed while comparing with the Standard W slurry.

The embodiments of this invention listed above, including the working example, are exemplary of numerous embodiments that may be made of this invention. It is contemplated that numerous other configurations of the process may be used, and the materials used in the process may be elected from numerous materials other than those specifically disclosed.

## Claims

1. A tungsten chemical mechanical polishing (CMP) composition comprising:
a) 0.1 wt% to 25 wt% nano-sized abrasive selected from the group consisting of silica, alumina, ceria, titania, zirconia, and combinations thereof;
b) 0.1 wt% to 0.5wt% solid catalyst of iron compound-coated particles selected from the group consisting of iron compound-coated colloidal silica, iron compound-coated colloidal inorganic metal oxide particles, iron compound-coated nano-sized inorganic metal oxide particles, and combinations thereof;
c) 0.0001 wt% to 0.5 wt% chemical additive selected from the group consisting of piperazine derivatives, salts of cyanate, and combinations thereof;
d) 0.5 wt% to 10 wt% oxidizer; and
e) liquid carrier;
wherein pH of the CMP composition is from about 2.0 to about 8.0.

2. The tungsten chemical mechanical polishing (CMP) composition of Claim 1, wherein the piperazine derivative has a general molecular structure of: 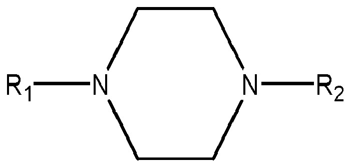 wherein R₁ and R₂ are independently selected from the group consisting of hydrogen, optionally substituted alkyl, optionally substituted aryl, optionally substituted aralkyl, optionally substituted alkoxy, optionally substituted organic group with one or more hydroxyl groups, optionally substituted organic sulfonic acid, optionally substituted organic sulfonic acid salt, optionally substituted keto, optionally substituted organic carboxylic acid, optionally substituted organic carboxylic acid salt, optionally substituted organic carboxylic ester, optionally substituted organic amine and optionally substituted organic carboxylic amide.

3. The tungsten chemical mechanical polishing (CMP) composition of Claim 1, wherein the piperazine derivative is optionally substituted organic mono-amino piperazine derivative (a) or optionally substituted organic bis-amino piperazine derivative (b) having molecular structures of: 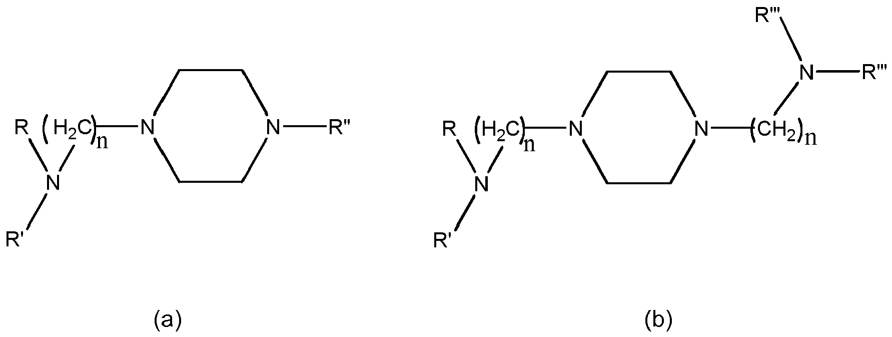 wherein
n is independently selected from 1 to 6; and
each R, R', R" and R'" is independently selected from the group consisting of hydrogen, optionally substituted alkyl, optionally substituted aryl, optionally substituted aralkyl, optionally substituted alkoxy, optionally substituted organic group with one or more hydroxyl groups, optionally substituted organic sulfonic acid, optionally substituted organic sulfonic acid salt, optionally substituted keto, optionally substituted organic carboxylic acid, optionally substituted organic carboxylic acid salt, optionally substituted organic carboxylic ester, optionally substituted organic amine and optionally substituted organic carboxylic amide.

4. The tungsten chemical mechanical polishing (CMP) composition of Claim 1, wherein the piperazine derivative is selected from the group consisting of (R)-piperazine-2-carboxylic acid; 1-(2-Hydroxyethyl)piperazine; Piperazine-2,6-dione; 1-(2-Aminoethyl)piperazine; 1,4-Bis(2-hydroxyethyl)piperazine; 1,4-Bis(acryloyl)piperazine; Piperazine-1-acetic acid *tert*-butyl ester; 1-(3-Methylbenzyl)piperazine; 4-Boc-piperazine-2-carboxylic acid; 1-(Diphenylmethyl)piperazine; 1,4-Di-Boc-piperazine-2-carboxylic acid; 2-(piperazine-1-carbonyl)-benzoic acid; 4-(Piperazine-1-carbonyl)-piperidine-1-carboxylic acid *tert*-butyl ester; piperazine-1-carboxylic acid; (2-chloro-phenyl)-amidepiperazine-1-carboxylic acid dimethylamide; piperazine-1-carboxylic acid diethylamide; piperazine-1-carboxylic acid diphenylamide; piperazine-1-sulfonamide; piperazine-2-carboxamide; 1,2-dimethyl-piperazine; 1-(2-butyl)-piperazine; 2-isobutyl-piperazine; 2-*tert*-butyl Piperazine; r-2-isobutyl-piperazine; s-2-isobutyl-piperazine; 2-isopropyl-piperazine; 1-(2-Pyrimidyl)piperazine; 1-(4-Trifluoromethylphenyl)piperazine; 1-(Cyclopropylmethyl)piperazine; 1-(2-pyrazinyl)-piperazine; 1-(2-trifluoromethylphenyl)-piperazine; 1-(6-Pyridazinyl)piperazine; 2-(4-trifluoromethylphenyl)piperazine; 2-phenyl-piperazine-1-carboxylic acid benzyl ester; 1-(1-Naphthylmethyl)piperazine; 1-(1-pentyl)piperazine; 1-(2-pentyl)-piperazine; 1-(3-pentyl)-piperazine; 1-(propanoyl)-piperazine; 2-phenyl-piperazine-1-carboxylic acid *tert*-butyl ester; 1-Boc-piperazine; 1-(4-Chlorophenyl)piperazine; 1-(2-Furoyl)piperazine; 1-(2-Fluorophenyl)piperazine; 1-(2-Hydroxyphenyl)piperazine; 1-(2-Phenylethyl)piperazine; 1-(4-Fluorophenyl)piperazine; 1-(2-Methylbenzyl)piperazine; 1-(4-Hydroxyphenyl)piperazine; 1-(4-Methylbenzyl)piperazine; 1-(3-Hydroxyphenyl) piperazine; 1-(1-phenylethyl)piperazine; 1-(2,4-Dimethylphenyl)piperazine; 1-(2,5-Dimethylphenyl)piperazine; 1-(2,5-Dimethylphenyl)piperazine; 1-(2,6-xylyl)piperazine; 1-(2-ethylphenyl)piperazine; 1-(2-ethylphenyl)piperazine; 1-(3,4-dimethylphenyl)piperazine; 1-(3,5-Dimethylphenyl)piperazine; 1-(3-fluorophenyl)piperazine; 1-(3-furoyl)piperazine; 1-(N-heptyl)piperazine; 1-Pivaloyl-piperazine; 2,3-Dimethyl-piperazine-1-carboxylic acid *tert*-butyl ester; 2-(2-chlorophenyl)piperazine; 2-(4-chlorophenyl)piperazine; n-4-cbz-piperazine-2-carboxylate methyl ester; 1-(2-Pyridyl)piperazine; 1-(2-Methoxyphenyl)piperazine; 1-(4-Methoxyphenyl)piperazine; 1-(4-Chlorobenzhydryl)piperazine; 1-(4-Pyridyl)piperazine; 1-(4-Aminophenyl)piperazine; 1-(4-Methoxybenzyl)piperazine; 1-(2-Cyanophenyl)piperazine; 1-(1-Adamantyl)piperazine; 1-(4-Nitrophenyl)piperazine; 1-(2-Methoxyethyl)piperazine; 2-(Trifluoromethyl)piperazine; 1-(3,4-Dichlorophenyl)piperazine; 1-Boc-piperazine-2-carboxylic acid; 1-(2,5-Difluorobenzyl)piperazine; 1-(2-Ethoxyethyl)piperazine; 1-(3,4-Dichlorobenzyl)piperazine; 1-(3-Methoxyphenyl)piperazine; 1-(Cyclohexylmethyl)piperazine; 1-(3-Methylphenyl)piperazine; 1-(4-Methylphenyl)piperazine; 1-(3-Fluorobenzyl)piperazine; 1-(4-Fluorobenzyl)piperazine; 2-(3-Methoxyphenyl)piperazine; 1-(3-Chlorobenzyl)piperazine; 1-(Cyclopropylcarbonyl)piperazine; (*R*)-1-Boc-piperazine-2-carboxylic acid; (R)-2-benzyl-piperazine; (R)-3-Hydroxymethyl-piperazine-1-carboxylic acid *tert*-butyl ester; (R)-4-N-Boc-piperazine-2-carboxylic acid; S)-2-benzyl-piperazine; (*S*)-2-Benzyl-piperazine-1-carboxylic acid *tert*-butyl ester; (S)-3-Hydroxymethyl-piperazine-1-carboxylic acid *tert-butyl* ester; (S)-4-N-Boc-piperazine-2-carboxylic acid; 1-(1-Piperidinylsulfonyl)piperazine; 1-(2,2,2-trifluoroethyl)piperazine; 1-(2,3-Difluorophenyl)piperazine; 1-(2,4,6-Trimethylbenzyl)piperazine; 1-(2,4-Dichlorobenzyl)piperazine; 1-(2,4-Difluorophenyl)piperazine; 1-(2,6-Dichlorobenzyl)piperazine; 1-(2-Chlorobenzyl)piperazine; 1-(2-Cyclohexylethyl)piperazine; 1-(2-diisopropylaminoethyl)piperazine; 1-(2-Dipropylaminoethyl)-piperazine; 1-(2-Ethoxyphenyl)piperazine; 1-(2-ethylbutanoyl)piperazine; 1-(2-Fluorobenzyl)piperazine; 1-(2-Isopropoxyethyl)piperazine; 1-(2-methylmercaptophenyl)piperazine; 1-(2-methylpropanoyl)-piperazine; 1-(2-morpholinoethyl)piperazine; 1-(2-Phenoxyethyl)piperazine; 1-(2-piperidinoethyl)piperazine; 1-(2-pyrrolidinoethyl)piperazine; 1-(3,3-dimethylbutanoyl)piperazine; 1-(3,4-dichlorobenzoyl)piperazine; 1-(3-(3,5-dichlorophenyl)piperazine; 4-difluorobenzoyl)piperazine; 1-(3,4-dimethylbenzyl)piperazine; 1-(3,5-dimethoxybenzoyl)piperazine; 1-(3,5-dimethylbenzoyl)piperazine; 1-(3-aminopropyl)piperazine; 1-(3-cyanopropyl)piperazine; 1-(3-diethylaminopropyl)piperazine; 1-(3-dipropylaminopropyl)-piperazine; 1-(3-methoxypropyl)-piperazine; 1-(3-morpholinopropyl)piperazine; 1-(3-Phenylpropyl)piperazine; 1-(3-piperidinopropyl)piperazine; 1-(3-pyrrolidinopropyl)piperazine; 1-(4-chlorobenzoyl)piperazine; 1-(4-Chlorobenzyl)piperazine; 1-(4-ethoxyphenyl)piperazine; 1-(4-methoxybenzoyl)-piperazine; 1-(4-methoxybutyl)piperazine; 1-(4-phenylbutyl)-piperazine; 1-(4-pyridylmethyl)piperazine; 1-(4-*tert*-Butylbenzyl)piperazine; 1-(Cyclohexylcarbonyl)piperazine; 1-(Ethanesulfonyl)piperazine; 1-(phenylacetyl)piperazine; 1-cbz-piperazine-2-carboxylic acid; 1-hexanoyl-piperazine; 1-methylsulfonyl-piperazine; 2,3-diphenyl-piperazine; 2-(2-Furyl)piperazine; 2-(2-Methoxyphenyl)piperazine; 2-(2-Thienyl)piperazine; 2-(3-oxo-piperazine-1-carbonyl)-benzoic acid; 2-(4-Chlorophenyl)piperazine-1-carboxylic acid *tert*-butyl ester; 2-(4-Methoxyphenyl)piperazine; 2-(4-methylphenyl)piperazine; 2-benzyl-piperazine; 3-(4-Chlorophenyl)piperazine-1-carboxylic acid *tert*-butyl ester; 3-oxo-piperazine-2-carboxylic acid; 3-phenylpiperazine-1-carboxylic acid ethyl ester; 4-(4-Boc-piperazine-1-carbonyl)phenylboronic acid pinacol ester; [5-(4-methyl-piperazine-1-sulfonyl)-pyridin-2-yl]-hydrazine; methyl piperazine-1-carboxylate; 1-ethyl-2-methyl-piperazine; 1,4-Bis(3-aminopropyl)piperazine; 1-[2-(2-Hydroxyethoxy)ethyl]piperazine; 1-(2-methyl-allyl)-piperazine; 2-(3-trifluoromethyl-phenyl)-piperazine; 4-*N*-Boc-2-methyl-piperazine; 1-(tetrahydro-2-furoyl)-piperazine; 1-(Tetrahydro-2-furylmethyl)piperazine; (*R*)-1-Boc-2-ethyl-piperazine; (*R*)-1-Boc-3-ethyl-piperazine; (*S*)-1-Boc-2-ethyl-piperazine; (*S*)-1-Boc-3-ethyl-piperazine; 1-[1-(2-methoxyphenyl)ethyl]piperazine; 1-[1-(3-methoxyphenyl)ethyl]piperazine; 1-[1-(4-methoxyphenyl)-ethyl]-piperazine; 1-[2-(2-Methylphenoxy)ethyl]piperazine; 1-(4-ethoxy-benzyl)-piperazine; 1-Boc-2,6-dimethyl-piperazine; 1-Boc-3,3-dimethyl-piperazine; 1-Boc-3,5-dimethyl-piperazine; 1-Boc-5-oxo-piperazine-2-carboxylic acid; 1-*N*-(*tert*-Butoxycarbonyl)-2-ethyl-piperazine; 2-(2-fluoro-phenyl)-piperazine; 2-(3-fluoro-phenyl)-piperazine; 2-methyl-1-(3-methylphenyl)piperazine; 4-(5-Aminopyridin-2-yl)piperazine-1-carboxylic acid *tert*-butyl ester; 1-[2-(Dimethylamino)ethyl]piperazine; 1-(1-Methyl-4-piperidinyl)piperazine; 1-Acetyl-4-(4-hydroxyphenyl)piperazine; 1-[4-(Trifluoromethyl)benzyl]piperazine; 1-Boc-4-(2-formylphenyl)piperazine; 1-Amino-4-(2-hydroxyethyl)piperazine; 1-Boc-(4-benzyl)piperazine; 1-Boc-4-[3-(ethoxycarbonyl)phenyl]piperazine; 1-Bis(4-fluorophenyl)methyl piperazine; 1-Boc-4-(3-hydroxypropyl)piperazine; 1-Boc-4-(4-formylphenyl)piperazine; 1-Boc-4-(4-methoxycarbonylphenyl)piperazine; 1-(1,3-Dioxolan-2-ylmethyl)piperazine; 1-(3-Aminopropyl)-4-(2-methoxyphenyl)piperazine; 1-[3-(Dimethylamino)propyl]piperazine; 1-(1,2,3,4-Tetrahydronaphthalen-2-yl)piperazine; 1-(4-Aminobutyl)-4-(2-methoxyphenyl)piperazine; 1-Boc-4-(2-methoxycarbonylphenyl)piperazine; 1-Boc-4-(5-nitro-2-pyridyl)piperazine; *(R)-1-*Boc-2-benzyl-piperazine; (*R*)-1-*N*-Boc-2-isopropyl piperazine; (*R*)-1-*N*-Boc-4-*N-*Fmoc-2-piperazine carboxylic acid; (R)-1-N-cbz-2-methyl-piperazine; (R)-4-N-trityl-2-methyl piperazine; (R)-N4-benzyl-2-(benzyloxymethyl)piperazine; (S)-1-Boc-2-hydroxymethyl-piperazine; (S)-1-Boc-2-isobutyl-piperazine; (*S*)-1-Boc-3-benzyl-piperazine; (*S*)-1-Boc-3-isopropyl-piperazine; (*S*)-1-*N*-Boc-4-*N*-Fmoc-piperazine-2-carboxylic acid; (S)-4-N-trityl-2-methyl-piperazine; (S)-4-benzyl-2-(methylthioethyl)piperazine; 1-[(2,6-dichlorophenyl)sulfonyl]piperazine; 1-[(2-Methyl-1,3-thiazol-5-yl)methyl]piperazine; 1-[(4,5-Dimethyl-1,3-oxazol-2-yl)methyl]piperazine; 1-[(4-cyclohexylphenyl)sulfonyl]piperazine; 1-[(4-Isobutylphenyl)sulfonyl]piperazine; 1-[(4-Methyl-1,2,5-oxadiazol-3-yl)methyl]piperazine; 1-[(4-sec-Butylphenyl)sulfonyl]piperazine; 1-[(4-*tert*-Butyl-2,6-dimethylphenyl)sulfonyl]piperazine; 1-[1-(pyridin-2-yl)ethyl]piperazine; 1-[1-(pyridin-3-yl)ethyl]piperazine; 1-[1-(thiophen-2-yl)ethyl]piperazine; 1-[2-(1-propyl)-oxyethyl]-piperazine; 1-[2-(1*H*-Pyrrol-1-yl)ethyl]piperazine; 1-[2-(2-methoxy-phenoxy)-ethyl]-piperazine; 1-[2-(diallylamino)-ethyl]-piperazine; 1-[2-(trifluoromethyl)pyridin-4-yl]piperazine; 1-[2-(trifluoromethyl)quinol-4-yl]piperazine; 1-[2-Fluoro-4-(methylsulfonyl)phenyl]piperazine; 1-[2-Fluoro-4-(methylsulphonyl)phenyl]-4-(2-hydroxyethyl)piperazine; 1-[3-(1-Piperidinylcarbonyl)-2-pyridinyl]piperazine; 1-[3-(difluoromethoxy)benzoyl]piperazine; 1-[3-(trifluoromethyl)pyrid-2-yl]piperazine; 1-[4-(methylsulfonyl)phenyl]piperazine; 1-[4-(trifluoromethyl)pyrimid-2-yl]piperazine; 1-(1H-Imidazol-2-ylmethyl)piperazine; 1-(2,6-Dimethylpyridin-4-yl)piperazine; 1-(2-benzhydryloxy-ethyl)-piperazine; 1-(2-hydroxyethyl)-4-isopropyl-piperazine; 1-(2-imidazol-1-yl-ethyl)-piperazine; 1-(2-isocyano-ethyl)-4-methyl-piperazine; 1-(2-Methyl-thiazol-4-ylmethyl)-piperazine; 1-(2-*N*-Boc-aminoethyl)piperazine; 1-(2-pyridin-2-yl-ethyl)-piperazine; 1-(2-pyridin-4-yl-ethyl)-piperazine; 1-(2-thiophen-2-yl-ethyl)piperazine; 1-(3,5-dimethyl-isoxazol-4-ylmethyl)-piperazine; 1-(3-methoxy-benzyl)-piperazine; 1-(3-methyl-benzoyl)-piperazine; 1-(3-methyl-pyridin-2-ylmethyl)-piperazine; 1-(3-Methylpyridin-2-yl)piperazine; 1-(3-methylpyridin-4-yl)piperazine; 1-(4,6-dimethylpyrimidin-2-yl)piperazine; 1-(4-cyano-benzyl)-piperazine; 1-(4-ethoxy-benzenesulfonyl)-piperazine; 1-(4-Ethoxy-pyridin-2-yl)-piperazine; 1-(4-Fluorobenzyl)-4-(2-hydroxyethyl)piperazine; 1-(4-Hydroxy-phenyl)-piperazine-4-carboxylic acid *tert*-butyl ester; *N*-Boc-piperidine; 2-Methylpiperazine; 2,6-Dimethylpiperazine; *trans*-2,5-Dimethylpiperazine; 1,4-Dimethylpiperazine; (*R*)-1-Boc-3-methylpiperazine; 1-Boc-3-oxopiperazine; 1,4-bis-(2-methoxy-5-methyl-benzenesulfonyl)-2-methyl-piperazine; 1-[(1-methyl-1 H-pyrazol-3-yl)carbonyl]piperazine; 1-[(1-methyl-1 H-pyrazol-4-yl)methyl]piperazine; 1-(2-(N,N-bis-(2-hydroxypropyl)-amino)-ethyl)-4-(2-hydroxypropyl)-piperazine; 1-(2-methoxyphenyl)-4-((4-(2-methoxyphenyl)-1-piperazinyl)(oxo)acetyl)piperazine; 1-(3-(2,3-dihydro-1,4-benzodioxin-6-yl)acryloyl)-4-(4-fluorophenyl)piperazine; 1-(4-chlorophenyl)-4-[(7-{[4-(4-chlorophenyl)-1-piperazinyl]sulfonyl}-9H-fluoren-2-yl)sulfonyl]piperazine; 1-(4-fluorophenyl)-4-((4-(4-fluorophenyl)-1-piperazinyl)(oxo)acetyl)piperazine; 1-(4-nitrophenyl)-4-(3-{[4-(4-nitrophenyl)-1-piperazinyl]carbonyl}benzoyl)piperazine; 1-(4-nitrophenyl)-4-(4-{[4-(4-nitrophenyl)-1-piperazinyl]carbonyl}benzoyl)piperazine; 1-acetyl-4-(1-ethyl-1h-imidazol-2-yl)piperazine; 1-benzhydryl-4-{2-[5-(benzylsulfanyl)-4-(2-methyl-2-propenyl)-4h-1,2,4-triazol-3-yl]ethyl}piperazine; 1-benzyl-4-[2-[(2',4'-difluoro[1,1'-biphenyl]-4-yl)oxy]ethyl]piperazine; 1-benzyl-4-(3-((2',4'-difluoro(1,1'-biphenyl)-4-yl)oxy)propyl)piperazine; 1-isopropyl-4-[(1-methyl-1 H-pyrrol-2-yl)methyl]piperazine; 1-methyl-4-({7-[(4-methyl-1-piperazinyl)sulfonyl]-9H-fluoren-2-yl}sulfonyl)piperazine; 1-phenyl-4-[phenyl(4-phenyl-1-piperazinyl)methyl]piperazine; 1-methyl-4-(methylsulfonyl)piperazine; 4-(2-hydroxy-ethyl)-piperazine-1-carboxylic acid (4-isopropyl-phenyl)-amide; 6-hydroxymethyl-1,3-dimethyl-piperazine-2,5-dione; bis(2-methoxyphenyl) 2,2'-(piperazine-1,4-diyl)diethanesulfonate; 1-(adamantane-1-sulfinyl)-4-methyl-piperazine; 1-(phenylsulfonyl)-4-(2-pyridinyl)piperazine; 1-benzyl-4-(2-methoxypropanoyl)piperazine; 1-cyclohexyl-4-(methylsulfonyl)piperazine; 1-ethyl-4-(3-furylmethyl)piperazine; 1-(3-phenoxy-4-pyridinyl)piperazine; 1-(2-pyridinyl)-4-(3-(2,3,4-trimethoxyphenyl)acryloyl)piperazine; 1-(3-(1,3-benzodioxol-5-yl)acryloyl)-4-(2-pyridinyl)piperazine; 1-(3-(1,3-benzodioxol-5-yl)acryloyl)-4-(4-methoxyphenyl)piperazine; 1,4-bis-(2-pyridylmethyleneamino)-piperazine; 1,4-bis-(3,4,5-trimethoxybenzylideneamino-piperazine; 1,4-bis-(acetoacetyl)-piperazine; 1,4-di(2-furoyl)piperazine; 1,4-bis[2-(4-pyridinyl)ethyl]piperazine; 1,4-bis(2-(2-pyridinyl)ethyl)piperazine; 1,4-bis(2-carboxybenzoyl)piperazine; 1,4-bis(3-pyridinylmethyl)piperazine; 1-(ethoxycarbonylmethyl)piperazine; 2,3,5,6-tetrahydroxy-piperazine-1,4-dicarbaldehyde; 4-benzyl-piperazine-1-carboxylic acid cyclohexylamide; diethyl 2,2'-(piperazine-1,4-diyl)bis(2-oxoacetate); diethyl 2,2'-(piperazine-1,4-diyl)diacetate; dimethyl 3,3'-(piperazine-1,4-diyl)dipropanoate; (2E,2'E)-3,3'-(piperazine-1,4-diyl)bis(1-(2-hydroxyphenyl)prop-2-en-1-one); 2,2'-(piperazine-1,4-diyl)bis(N-(1,5-dimethyl-3-oxo-2-phenyl-2,3-dihydro-1H-pyrazol-4-yl)acetamide); 2,2'-(piperazine-1,4-diyl)dipropanamide; 2,2'-(piperazine-1,4-diyl)dipropanenitrile; 3,3'-(piperazine-1,4-diyl)bis(1-(9H-carbazol-9-yl)propan-2-ol) fumarate; 3,3'-(piperazine-1,4-diyl)bis(1-phenylpropan-1-one); 3,3'-(piperazine-1,4-diyl)dipropan-1-ol; 4,4'-(piperazine-1,4-diyl)bis(3-ethoxycyclobut-3-ene-1,2-dione; piperazine-1,4-dicarbothioic acid bis-phenylamide; 1,4-di-tert-butyl-piperazine-2,5-dione; 1,4-didodecyl-piperazine; 1,4-dihexadecyl-piperazine; 1-(1-piperidinylcarbonyl)piperazine; 1-(1-adamantylmethyl)piperazine; 1-(3,4-dimethoxybenzyl)piperazine; 1-(3-pyridinylcarbonyl)piperazine; 4-Piperazinobenzonitrile; (S)-3-Methyl-2-ketopiperazine; (R)-3-Methyl-2-ketopiperazine; 4-(Boc-piperazin-1-yl)-3-nitrobenzoic acid; 1,1'-(piperazine-1,4-diyl)dipropan-2-ol; 2,2'-(piperazine-1,4-diyl)bis(1-phenylethanol); 2,2'-(piperazine-1,4-diyl)bis(2-methylpropanenitrile); Piperazine-N,N'-bis(2-ethanesulfonic acid); 1-Formylpiperazine; PIPES sodium salt; PIPES disodium salt; PIPES dipotassium salt; Piperazine-N,N'-bis(2-hydroxypropanesulfonic acid); Ethyl 1-piperazinecarboxylate; POPSO disodium salt; 4-Hydroxy-3-methoxyphenylglycol hemipiperazinium salt; Citric acid sesquipiperazine salt hydrate; 4-(2-Hydroxyethyl)piperazine-1-ethanesulfonic acid; 4-(2-Hydroxyethyl)-1-piperazinepropanesulfonic acid; HEPES sodium salt; N-(2-Hydroxyethyl)piperazine-N'-(4-butanesulfonic acid); 3-Methyl-2-ketopiperazine; HEPES potassium salt; 3-Piperazinopropionitrile; Ethyl piperazinoacetate; Estropipate; 1-Piperazinepropanol; t-butyl-4-(2-Amino-1-phenylethyl)piperazine carboxylate; *tert-*Butyl 4-[2-(aminomethyl)phenyl]piperazine-1-carboxylate; *tert-*Butyl 4-[5-(hydroxymethyl)pyrid-2-yl]piperazine-1-carboxylate; *tert-*Butyl 4-(3-aminobenzyl)piperazine-1-carboxylate; *tert-*Butyl 4-(4-[(methylamino)methyl]phenyl)piperazine-1-carboxylate; *tert-*Butyl 4-(4-cyanopyrid-2-yl)piperazine-1-carboxylate; *tert-*Butyl 4-(5-formylpyrid-2-yl)piperazine-1-carboxylate; tert-Butyl 4-(oxetan-3-yl)piperazine-1-carboxylate; *tert-*Butyl 4-(piperidin-3-yl)piperazine-1-carboxylate; *tert-*Butyl 4-(pyrrolidin-2-ylcarbonyl)piperazine-1-carboxylate; tert-Butyl 4-(1 H-pyrrolo[2,3-b]pyridin-4-yl)piperazine-1-carboxylate; 1-[2-(2,5-dimethyl-1 H-pyrrol-1-yl)ethyl]piperazine; 1-((1,5-dimethyl-1 H-pyrazol-4-yl)methyl)piperazine; 1-(1-Ethyl-5-methyl-1H-pyrazol-4-ylmethyl)-piperazine; t-butyl4-(2-Amino-1-[4-(trifluoromethyl)phenyl]ethyl)piperazine carboxylate; 3-(4-Fluoro-phenyl)-piperazine-1-carboxylic acid *tert*-butyl ester; 3-(4-Hydroxy-phenyl)-piperazine-1-carboxylic acid *tert*-butyl ester; 3-Furan-2-yl-piperazine-1-carboxylic acid *tert*-butyl ester; 3-thiophen-2-yl-piperazine-1-carboxylic acid benzyl ester; 4-(2-Amino-phenyl)-piperazine-1-carboxylic acid *tert*-butyl ester; 4-(2-Aminoethyl)-1-boc-piperazine; 4-(5-Carboxy-pyridin-2-yl)-2-methyl-piperazine-1-carboxylic acid *tert-*butyl ester; 4-Boc-1-(6-methyl-2-pyridyl)piperazine; Fmoc-4-carboxymethyl-piperazine; Methyl 4-Boc-piperazine-2-carboxylate; N,N-dimethyl-1-piperazine sulfonamide; *N*-1-Boc-*N*-4-Fmoc-2-Piperazine carboxylic acid; *N*-4-Boc-*N*-1-cbz-2-piperazine carboxylic acid; *N*-4-Boc-*N*-1-Fmoc-2-Piperazine acetic acid; sulfuric acid compound with piperazine-1-carboximidamide (1:1); 1-ethyl-4-piperidin-4-yl-piperazine; 1-furan-2-ylmethyl-piperazine; 1-methyl-4-(2-piperidin-4-yl-ethyl)-piperazine; 1-Methyl-4-(6-aminopyridin-3-yl)piperazine; 1-methyl-4-(piperidin-4-yl)-piperazine; 1-*N*-Boc-4-(azetidin-3-yl)piperazine; 1-pyridin-2-ylmethyl-piperazine; 1-Pyridin-3-ylmethyl-piperazine; 1-thiazol-2-yl-piperazine; 2-(2,5-dimethoxy-phenyl)-piperazine; 2-Carboxymethyl-3-oxo-piperazine-1-carboxylic acid *tert*-butyl ester; 2-Ethoxycarbonylmethyl-3-oxo-piperazine-1-carboxylic acid *tert*-butyl ester; 1-(4-methyl-cyclohexyl)-piperazine; 1-(4-methyl-piperidine-1-sulfonyl)-piperazine; 1-(4-trifluoromethyl-pyridin-2-yl)-piperazine; 1-(5-Methyl-2-pyridinyl)piperazine; 1-(5-Methyl-2-thiazolyl)-piperazine; 1-(5-Nitropyridin-2-yl)piperazine; 1-(6-Butoxy-2-pyridinyl)piperazine; 1-(6-methylpyrid-2-yl)piperazine; 1-(N-Methylpiperidin-3-yl-methyl)piperazine; 1-(thien-2-ylacetyl)piperazine; 1-Boc-4-(piperidin-4-yl)-piperazine; 1-Boc-4-cyanomethyl piperazine; 1-cyclohex-3-enylmethyl-piperazine, and combinations thereof.

5. The tungsten chemical mechanical polishing (CMP) composition of Claim 1, wherein the piperazine derivative is selected from the group consisting of (R)-piperazine-2-carboxylic acid; 1-(2-Hydroxyethyl)piperazine; Piperazine-2,6-dione; 1-(2-Aminoethyl)piperazine; 1,4-Bis(2-hydroxyethyl)piperazine; 1,4-Bis(acryloyl)piperazine; Piperazine-1-acetic acid *tert*-butyl ester; 1-(3-Methylbenzyl)piperazine; 4-(Piperazine-1-carbonyl)-piperidine-1-carboxylic acid *tert-*butyl ester; piperazine-1-carboxylic acid diethylamide; piperazine-1-sulfonamide; piperazine-2-carboxamide; 1,2-dimethyl-piperazine; 2-isopropyl-piperazine; 1-(2-Pyrimidyl)piperazine; 1-(2-pyrazinyl)-piperazine; 1-(6-Pyridazinyl)piperazine; 1-(3-Hydroxyphenyl) piperazine; 1-(2-Pyridyl)piperazine; 1-(4-Methoxyphenyl)piperazine; 1-(4-Pyridyl)piperazine; 1-(4-Aminophenyl)piperazine; 1-(4-Methoxybenzyl)piperazine; 1-(2-Cyanophenyl)piperazine; 1-(2-Methoxyethyl)piperazine; 1-Boc-piperazine-2-carboxylic acid; 1-(2-Ethoxyethyl)piperazine; (*R*)-1-Boc-piperazine-2-carboxylic acid; (R)-3-Hydroxymethyl-piperazine-1-carboxylic acid *tert-butyl* ester; (*R*)-4-N-Boc-piperazine-2-carboxylic acid; (*S*)-3-Hydroxymethyl-piperazine-1-carboxylic acid *tert*-butyl ester; (*S*)-4-*N*-Boc-piperazine-2-carboxylic acid; 1-(1-Piperidinylsulfonyl)piperazine; 1-(2-diisopropylaminoethyl)piperazine; 1-(2-Dipropylaminoethyl)-piperazine; 1-(2-Ethoxyphenyl)piperazine; 1-(2-ethylbutanoyl)piperazine; 1-(2-Isopropoxyethyl)piperazine; 1-(2-methylmercaptophenyl)piperazine; 1-(2-morpholinoethyl)piperazine; 1-(2-piperidinoethyl)piperazine; 1-(2-pyrrolidinoethyl)piperazine; 1-(3-aminopropyl)piperazine; 1-(3-cyanopropyl)piperazine; 1-(3-diethylaminopropyl)piperazine; 1-(3-dipropylaminopropyl)-piperazine; 1-(3-methoxypropyl)-piperazine; 1-(3-morpholinopropyl)piperazine; 1-(3-piperidinopropyl)piperazine; 1-(3-pyrrolidinopropyl)piperazine; 1-(4-methoxybutyl)piperazine; 1-(4-pyridylmethyl)piperazine; 1-(Ethanesulfonyl)piperazine; 3-oxo-piperazine-2-carboxylic acid; 4-methyl piperazine-1-carboxylate; 1,4-Bis(3-aminopropyl)piperazine; 1-[2-(2-Hydroxyethoxy)ethyl]piperazine; 4-(5-Aminopyridin-2-yl)piperazine-1-carboxylic acid *tert*-butyl ester; 1-[2-(Dimethylamino)ethyl]piperazine; 1-(1-Methyl-4-piperidinyl)piperazine; 1-Amino-4-(2-hydroxyethyl)piperazine; 1-(3-Aminopropyl)-4-(2-methoxyphenyl)piperazine; 1-[3-(Dimethylamino)propyl]piperazine; 1-(4-Aminobutyl)-4-(2-methoxyphenyl)piperazine; 1-[3-(1-Piperidinylcarbonyl)-2-pyridinyl]piperazine; 1-(1H-Imidazol-2-ylmethyl)piperazine; 1-(2,6-Dimethylpyridin-4-yl)piperazine; 1-(2-hydroxyethyl)-4-isopropyl-piperazine; 1-(2-imidazol-1-yl-ethyl)-piperazine; 1-(2-isocyano-ethyl)-4-methyl-piperazine; 1-(4-Ethoxy-pyridin-2-yl)-piperazine; 2-Methylpiperazine; 2,6-Dimethylpiperazine; trans-2,5-Dimethylpiperazine; 1,4-Dimethylpiperazine; 1,4-bis(3-pyridinylmethyl)piperazine; 1-(ethoxycarbonylmethyl)piperazine; 2,3,5,6-tetrahydroxy-piperazine-1,4-dicarbaldehyde; dimethyl 3,3'-(piperazine-1,4-diyl)dipropanoate; 2,2'-(piperazine-1,4-diyl)dipropanamide; 2,2'-(piperazine-1,4-diyl)dipropanenitrile; (R)-3-Methyl-2-ketopiperazine; 2,2'-(piperazine-1,4-diyl)bis(2-methylpropanenitrile); Piperazine-N,N'-bis(2-ethanesulfonic acid); 1-Formylpiperazine; PIPES sodium salt; PIPES disodium salt; PIPES dipotassium salt; Piperazine-N,N'-bis(2-hydroxypropanesulfonic acid); Ethyl 1-piperazinecarboxylate; POPSO disodium salt; 4-Hydroxy-3-methoxyphenylglycol hemipiperazinium salt; 4-(2-Hydroxyethyl)piperazine-1-ethanesulfonic acid; 4-(2-Hydroxyethyl)-1-piperazinepropanesulfonic acid; HEPES sodium salt; N-(2-Hydroxyethyl)piperazine-N'-(4-butanesulfonic acid); 3-Methyl-2-ketopiperazine; HEPES potassium salt; 3-Piperazinopropionitrile; Ethyl piperazinoacetate; and combinations thereof.

6. The tungsten chemical mechanical polishing (CMP) composition of Claim 1, wherein the piperazine derivative is selected from the group consisting of 1-(2-aminoethyl) piperazine, 1,4-bis(3-aminopropyl)piperazine and combinations thereof.

7. The tungsten chemical mechanical polishing (CMP) composition of any one of the preceding claims, wherein the chemical additive is or comprises salt of cyanate selected from the group consisting of potassium cyanate, sodium cyanate, ammonium cyanate, alkylammonium cyanate, and combinations thereof.

8. The tungsten chemical mechanical polishing (CMP) composition of any one of the preceding claims, further comprising one or more of
a corrosion inhibitor;
a pH buffering agent;
a surfactant; and
a biocide when pH of the polishing composition is from 5.0 to 8.0.

9. The tungsten chemical mechanical polishing (CMP) composition of any one of the preceding claims, wherein the remainder of the composition is substantially liquid carrier.

10. The tungsten chemical mechanical polishing (CMP) composition of any one of the preceding claims wherein the nano-sized abrasive is colloidal silica; the solid catalyst is ferric oxide-coated colloidal silica; the chemical additive is 1-(2-aminoethyl)piperazine or potassium cyanate; the oxidizer is hydrogen peroxide; the corrosion inhibitor polyethylenimine is optionally present; and the remainder of the composition is deionized water.

11. A process of selective chemical mechanical polishing, comprising the steps of:
a) providing a semiconductor substrate having a surface containing tungsten and at least one other material;
b) providing a polishing pad;
c) providing a tungsten chemical mechanical polishing (CMP) composition as claimed in any one of the preceding claims;
d) contacting the surface of the semiconductor substrate with the polishing pad and the chemical mechanical polishing composition; and
e) polishing the surface of the semiconductor substrate;
wherein at least a portion of the surface containing tungsten is in contact with both the polishing pad and the chemical mechanical polishing composition; and the ratio of removal rate of tungsten to removal rate of the at least one other material is equal or greater than 1.

12. A system of selective chemical mechanical polishing comprising:
a) a polishing pad;
b) a tungsten chemical mechanical polishing (CMP) composition as claimed in any one of Claims 1-10.

13. A system as claimed in Claim 12, further comprising a semiconductor substrate having a surface containing tungsten and at least one other material; wherein at least a portion of the surface containing tungsten is in contact with both the polishing pad and the chemical mechanical polishing composition.
